# EUROPÄISCHE PATENTSCHRIFT

(11) **EP 3 559 747 B1**
(45) Veröffentlichungstag und Bekanntmachung des Hinweises auf die Patenterteilung: **18.03.2026**
(21) Anmeldenummer: 16828721.7
(22) Anmeldetag: 20.12.2016
(51) Int. Cl.: G03F 7/00, G03F 7/20

(54) **VORRICHTUNG UND VERFAHREN ZUR BELICHTUNG EINER LICHTEMPFINDLICHEN SCHICHT**
DEVICE AND METHOD FOR EXPOSING A LIGHT-SENSITIVE LAYER
DISPOSITIF ET PROCÉDÉ D'EXPOSITION D'UNE COUCHE PHOTOSENSIBLE

(43) Veröffentlichungstag der Anmeldung: 30.10.2019
(73) Patentinhaber: EV Group E. Thallner GmbH, St. Florian am Inn (AT)
(72) Erfinder: THALLNER, Bernhard, 4782 St. Florian am Inn (AT); POVAZAY, Boris, 1220 Wien (AT)
(74) Vertreter: Schneider, Sascha
(86) Internationale Anmeldenummer: PCT/EP2016/081880
(87) Internationale Veröffentlichungsnummer: WO 2018/113917

(56) Entgegenhaltungen:
- EP-A2- 0 467 076
- DE-A1- 102005 054 000
- US-A1- 2006 269 217

## Beschreibung

Die vorliegende Erfindung betrifft ein Verfahren zur Belichtung einer lichtempfindlichen Schicht gemäß Anspruch 1 sowie eine korrespondierende Vorrichtung gemäß Anspruch 8.

Mikrospiegelvorrichtungen (engl.: Digital Micromirror Device, DMD) sind im Stand der Technik bereits seit langem bekannt. Es handelt sich dabei um optische Elemente, die aus einer Vielzahl kleiner Spiegel bestehen, die einzeln bewegt/ausgerichtet werden können. Jeder Spiegel kann gezielt elektrisch angesteuert und orientiert werden. Dadurch kann ein optisches System mit einem DMD dazu verwendet werden, um einen breiten Lichtstrahl selektiv ortsaufgelöst abzulenken. Meistens werden pro Spiegel nur zwei voll ausgelenkte Positionen betrachtet. Entweder ein Spiegel lässt den Teil des Lichtstrahls, der auf ihn fällt durch das optische System weiter passieren oder er reflektiert den Teil des Lichtstrahls so, dass das Licht im optischen System nicht weitergeführt wird. Man kann dann jeden Spiegel eines solchen DMDs als digitalen Lichtschalter interpretieren.

Derartige DMDs werden im Stand der Technik vor allem bereits in Projektoren eingesetzt. Zunehmend finden DMD auch Anwendung im industriellen Umfeld, wie z.B. beim 3D-Druck, der 3D-Vermessung und maskenlosen Lithographie.

Im Stand der Technik sind ausschließlich maskenlose Belichter bekannt, die über eine einzige Lichtquelle verfügen, welche das DMD und damit die zu belichtende Oberfläche bestrahlen. Derartige Belichter sind etwa in DE 10 2005 054000 A1 und EP 0 467 076 A2 gezeigt.

Es ist daher die Aufgabe der vorliegenden Erfindung, die Nachteile des Stands der Technik zu beseitigen und insbesondere ein verbessertes Belichtungsergebnis zu erzielen.

Diese Aufgabe wird mit den Gegenständen der nebengeordneten Patentansprüche sowie den nachfolgend offenbarten Erfindungsgedanken gelöst. Vorteilhafte Weiterbildungen der Erfindung sind in den Unteransprüchen angegeben.

Die Erfindung zeigt insbesondere auf, wie ein verbesserter, schnellerer, höher aufgelöster Belichtungsvorgang durchgeführt werden kann und wie gleichzeitig eine Belichtung in unterschiedlichen Fokustiefen erfolgen kann.

Der Kerngedanke der Erfindung besteht darin, Mikrospiegel einer Mikrospiegeleinrichtung eines optischen Systems derart auszubilden, dass jedes Spiegelintensitätsprofil der Mikrospiegel mit jeweils benachbarten Spiegelintensitätsprofilen überlagert wird beziehungsweise überlagerbar ausgebildet ist. Jedes Spiegelintensitätsprofil besteht somit aus einem dem Bildpunkt/Pixel entsprechenden Bereich und einem den Bildpunkt/Pixel umgebenden Bereich. Die Spiegelintensitätsprofile werden zumindest überwiegend, vorzugsweise vollständig, durch die optischen Elemente und durch die geometrische Form der Mikrospiegel definiert. Die Mikrospiegel sind vorzugsweise rechteckig, noch bevorzugter quadratisch. Denkbar wären auch runde oder dreieckige Mikrospiegel. Aus den Bildpunkten/Pixeln einschließlich Überlagerungen wird ein (DMD-)Bild gebildet.

Es entsteht insbesondere ein Belichtungsraster aus mehreren, zumindest teilweise überlagerten Spiegelintensitätsprofilen mit einem Rasterintensitätsprofil. Das Rasterintensitätsprofil ist somit eine Summe der überlagerten Spiegelintensitätsprofile. Das Belichtungsraster belichtet vorzugsweise einen Teilbereich einer zu belichtenden Schicht auf einem Substrat, wobei das Rasterintensitätsprofil des Belichtungsrasters durch die Überlagerung vorzugsweise homogener ist als ein Belichtungsraster aus dem Stand der Technik ohne Überlagerung.

Das Spiegelintensitätsprofil wird vorzugsweise so gewählt oder eingestellt oder gesteuert, dass 50% der vom jeweiligen Spiegel abgelenkten Energie auf den entsprechenden Bildpunkt/Pixel treffen. Weitere 50% der vom jeweiligen Spiegel abgelenkten Energie werden auf den jeweiligen Bildpunkt/Pixel umgebende Bildpunkte/Pixel aufgeteilt. In einer bevorzugteren erfindungsgemäßen Ausführungsform wird das Spiegelintensitätsprofil so gewählt oder eingestellt oder gesteuert, dass mehr als 50%, noch bevorzugter mehr als 60%, noch bevorzugter mehr als 70%, der vom jeweiligen Spiegel abgelenkten Energie auf den entsprechenden Bildpunkt/Pixel treffen. Die verbleibende Energie wird auf die den jeweiligen Bildpunkt/Pixel umgebende Bildpunkte/Pixel aufgeteilt.

In einer anderen, weniger bevorzugten erfindungsgemäßen Ausführungsform wird das Spiegelintensitätsprofil so gewählt, dass weniger als 50% der vom jeweiligen Spiegel abgelenkten Energie auf den entsprechenden Bildpunkt/Pixel treffen.

Die Erfindung beschreibt insbesondere eine maskenlose Belichtungsvorrichtung beziehungsweise ein maskenloses Belichtungsverfahren. Der Belichter wird in mehreren, miteinander kombinierbaren Ausführungsformen beschrieben. Insbesondere handelt es sich um unabhängige, aber miteinander kombinierbare Optimierungsmöglichkeiten.

Die wichtigste Ausführungsform besteht in der Auslegung des optischen Systems in der Art und Weise, dass es zur Überlappung der einzelnen Bildpunkte (durch das optische System erzeugte Pixel), insbesondere mit einer Überlagerung und/oder Interferenzen kommt. Dies wird insbesondere dadurch bewirkt, dass die Intensitätsprofile der reflektierten Strahlen der nebeneinanderliegenden Mikrospiegel überlagert werden.

Insbesondere wird eine maskenlose Belichtungsvorrichtung mit mindestens zwei Lichtquellen offenbart, wobei die Lichtstrahlen der Lichtquellen insbesondere überlagert oder zusammengeführt beziehungsweise gemischt werden. Erfindungsgemäß denkbar wäre auch eine maskenlose Belichtungsvorrichtung mit integrierter Messtechnik. Eine weitere Ausführungsform betrifft einen maskenlosen Belichter, der eine gleichzeitige Belichtung in unterschiedlichen Fokusebenen oder spektral unterschiedlichen Teilbildern erlaubt. Gemäß einer weiteren alternativen Ausführungsform wird ein Belichter mit einem anisotropen oder verzerrenden optischen System zur Erzielung einer höheren Auflösung offenbart.

Eine weitere, insbesondere eigenständig offenbarte Implementation betrifft die Methode des "De-scannings" zur Durchsatz- und Auflösungserhöhung. Hierbei wird der, insbesondere kontinuierlich und/oder sequentiell abtastende, Belichtungsprozess durch eine zweite Ablenkung in einer oder zwei Richtungen überlagert, die das Belichtungsfeld quasistatisch mit einer feineren Positionierungsgenauigkeit als die Pixelgröße festhalten, um sowohl Bewegungsunschärfe als auch Kantenpositionen zu reduzieren.

Des Weiteren werden Ausführungsformen offenbart, bei denen das optische System zwischen dem DMD und der zu belichtenden, lichtempfindlichen Schicht (zu belichtendes Material) eine orthogonal (insbesondere parallel zur Oberfläche der zu belichtenden Schicht) verzerrte Darstellung des Urbildes erzeugt. Durch die optische Verzerrung des Bildes kann insbesondere die Positioniergenauigkeit bzw. der Overlay erhöht werden. Unter der Positioniergenauigkeit zu einer bestehenden Struktur versteht man im speziellen Fall, dass durch die erfindungsgemäße verzerrte Darstellung des Urbildes die Auflösung der zu schreibenden Strukturen erhöht wird.

### Vorteile der Erfindung

Es werden keine Masken benötigt, so dass die gewünschte Struktur direkt in eine lichtempfindliche (photosensitive) Schicht belichtet werden kann. Durch die Verwendung mehrerer Lichtquellen kann das Spektrum breiter gewählt sowie die Lichtleistung und damit der erzielbare Durchsatz erhöht werden. Durch ein Kippen der Fokusebene gegenüber der Oberfläche der zu belichtenden Schicht oder individuelle Wahl der Wellenlängen kann simultan in unterschiedlichen Tiefen mit der vollen Auflösung beziehungsweise selektiv in unterschiedlichen Ebenen belichtet werden.

Erfindungsgemäß weist die Vorrichtung insbesondere ein optisches System mit folgenden Merkmalen auf:
- mindestens eine Lichtquelle zur Erzeugung mindestens eines Lichtstrahls,
- mindestens eine Mikrospiegeleinrichtung mit einer Vielzahl von Mikrospiegeln, wobei jeder Mikrospiegel zur Beleuchtung eines Pixels eines Belichtungsrasters mit einem Spiegelintensitätsprofil dient,
wobei das optische System derart ausgebildet ist, dass eine Überlagerung von Spiegelintensitätsprofilen benachbarter Mikrospiegel zu einem Rasterintensitätsprofil des Belichtungsrasters als Summe der Spiegelintensitätsprofile jedes beleuchteten Pixels des Belichtungsrasters erfolgt.

Die Erfindung beschreibt eine Methode und eine Anlage, um mit Hilfe eines Lichtstrahlenbündels, insbesondere eines Lasers, das durch ein optisches System, bestehend aus mindestens einer, vorzugsweise digitalen, Mikrospiegelvorrichtung (engl.: Digital Micromirror Device, DMD), geleitet wird, eine lichtempfindliche Schicht zu bestrahlen. Die Bestrahlung der Schicht führt zu einer physikalischen und/oder chemischen Veränderung der Schicht.

Die erfindungsgemäßen Ausführungsformen können insbesondere als
- vollflächige
- kontinuierlich abtastende (scannende)
- schrittweise (steppende)
maskenlose Belichter konzipiert werden. Als "maskenlos" wird der Ersatz der Abbildung einer statischen Vorlage (Maske, Reticle) durch ein dynamisch optisch musterndes System verstanden.

Unter einem vollflächigen, maskenlosen Belichter versteht man eine Anlage, welche über ein DMD verfügt, das den gesamten zu beschreibenden Bereich belichten kann, ohne nennenswerte relative Verschiebung zwischen der zu belichtenden Schicht und dem optischen System. Damit können nach heutigem Stand der Technik nur sehr kleiner Substrate belichtet werden, da die Größe heutiger DMDs begrenzt ist.

Unter einem abtastenden (scannenden), maskenlosen Belichter wird eine Vorrichtung beziehungsweise ein Verfahren verstanden, bei der/dem das Belichtungsfeld kleiner als der zu belichtende Bereich ist, sodass eine relative Verschiebung zwischen dem optischen System und der zu belichtenden Schicht erfolgt, um das gesamte Belichtungsfeld zu belichten. Diese relative Verschiebung erfolgt insbesondere kontinuierlich entlang eines Pfades. Der Pfad ist vorzugsweise:
- Mäanderförmig
- Zeilenförmig mit Verschiebung in die nächste Zeile und Rückstellung an den Anfang bei Erreichen des Endes,
- Spiralförmig,
- Kreisförmig,
- Linear.

Insbesondere können die genannten Pfade auch miteinander kombiniert werden. So ist es denkbar, zuerst einen spiralförmigen Pfad zur Belichtung zu verwenden, gefolgt von einem linearen Pfad, der insbesondere durch das Zentrum des Substrats führt oder mehrere anfangs unabhängige Schreibfade einander ergänzen. Bevorzugt wird mäanderförmig gefahren.

Unter einem steppenden maskenlosen Belichter versteht man eine Anlage, bei der das Belichtungsfeld kleiner als der zu belichtenden Bereich ist, die relative Verschiebung zwischen dem optischen System und der zu belichtenden Schicht schrittweise erfolgt und zwischen den einzelnen Schritten keine Belichtung erfolgt. Erst wenn optisches System und die zu belichtende Schicht sich in einer wohldefinierten Position befinden, belichtet das optische System die zu belichtende Schicht. Bei dieser Ausführungsform handelt es sich also um ein Belichten mehrerer Teilbereiche der zu belichtende Schicht.

### Das DMD Prinzip

Ein DMD erlaubt die gezielte Ablenkung, insbesondere mehrerer Teile, eines breiten primären, vorzugsweise parallelen und/oder nicht streuenden, Strahlenbündels. Dadurch kann, ohne Zuhilfenahme einer Maske, ein räumlich strukturiertes, sekundäres optisches Belichtungsstrahlenbündel erzeugt werden. Dem DMD sind meistens Optiken, insbesondere Projektionsoptiken, vor- und/oder nachgelagert, welche den auf das DMD fallenden primären Belichtungsstrahl und/oder die vom DMD reflektierten sekundären Belichtungsstrahlen manipulieren (insbesondere skalieren) können, und bei der Mikrolithographie insbesondere eine Verkleinerung des DMD Bildes erzeugen können. Dadurch kann das DMD-Bild entsprechend verkleinert werden.

Die dadurch erreichbare Strukturauflösung eines DMDs liegt insbesondere zwischen 0.1 µm und 50 µm, vorzugsweise zwischen 0.3 µm und 25 µm, noch bevorzugter zwischen 1 µm und 10 µm.

Vor allem für Ausführungsformen, bei denen das individuelle Belichtungsfeld kleiner als das Substrat ist, ist es von Bedeutung, dass nach einer Relativbewegung zwischen dem optischen System und der zu belichtenden Schicht eine nahtlose Weiterführung der zu erzeugenden Strukturen erfolgt. Beim Steppen erfolgt das in zwei unabhängigen Richtungen, beim kontinuierlichen Abtasten meist nur in einer.

### Das optische System

Die erfindungsgemäßen Ausführungsformen bestehen aus mindestens einem optischen System, welches mehrere optische Elemente unterschiedlicher Art beinhalten kann. Mindestens eines der optischen Elemente ist ein DMD, obwohl die Verwendung mehrerer DMDs eine weitere erfindungsgemäße Ausführungsform darstellt. Insbesondere befinden sich genau ein DMD, vorzugsweise mindestens zwei DMDs, noch bevorzugter mindestens vier DMDs im optischen System. Das optische System selbst kann in einer oder mehreren Formen parallel auf einem Substrat innerhalb einer Anlage zum Einsatz kommen. Auch das parallele Belichten mehrerer Substrate innerhalb der Anlage ist erfindungsgemäß denkbar.

Im optischen System können sich des Weiteren folgende optischen Elemente befinden:
- Beleuchtungsoptik
   ∘ Kohärente Lichtquellen, insbesondere
      - Laserlichtquellen
         - Laserdioden
         - Festkörperlaser
         - Excimerlaser
   ∘ Inkohärente Lichtquellen, insbesondere
      ▪ Gasentladungslampen, insbesondere
         - Quecksilberdampflampen
      ▪ LED
   ∘ Teilkohärente Lichtquellen
   ∘ Kohärenzändernde Komponenten
- Ablenkungsoptik
   ∘ DMDs
   ∘ Spiegel, insbesondere
      ▪ Kaltspiegel
      ▪ Warmspiegel
   ∘ Refraktionselemente, insbesondere
      ▪ Prismen
      ▪ Strahlteiler
- Projektionsoptik
   ∘ Linsen, insbesondere
      ▪ Fresnellinsen
      ▪ Refraktionslinsen
         - Konvexlinsen
         - Konkavlinsen
         - Bikonkavlinsen
         - Bikonvexlinsen
         - Konvexkonkavlinsen
         - Konkavkonvexlinsen
         - Zylinderlinsen
         - Verbundlinsen
   ∘ Spiegel, insbesondere
      ▪ Zylinderspiegel
   ∘ Allgemeine strahlverändernde optische Komponenten

Die Lichtquellen können kontinuierlich oder gepulst verwendet, insbesondere zusätzlich intern oder extern moduliert, werden.

Die maximal mögliche Relativgeschwindigkeit zwischen dem optischen System und der zu belichtenden Schicht wird insbesondere durch die maximale Ansteuerungsfrequenz des DMDs (also der Frequenz, mit der die einzelnen Spiegelelemente eines DMD tatsächlich geschaltet werden können) beschränkt. Die Relativgeschwindigkeit in einem scannenden System ist des Weiteren durch die Verschiebe- und/oder Ablenkoptik bestimmt und liegt insbesondere zwischen 5 mm/s und 500 mm/s, vorzugsweise zwischen 10 mm/s und 250 mm/s, noch bevorzugter zwischen 15 mm/s und 200 mm/s am bevorzugtesten zwischen 25 mm/s und 100 mm/s.

Ein weiterer wichtiger Aspekt einer erfindungsgemäßen Ausführungsform besteht darin, eine höhere Vorschubgeschwindigkeit zu verwenden als durch die Rastergröße und Abtastfrequenz definiert ist. Durch die Wahl einer entsprechend höheren Vorschubgeschwindigkeit werden Zeilen ausgelassen, die durch, zeitlich gesehen, spätere Belichtungszeilen des DMD ergänzt werden.

Um ein Verwaschen der Belichtung in Scanrichtung zu verhindern, wird die Belichtung unterbrochen und/oder ein lokaler "De-Scan"-Mechanismus verwendet, der die Belichtungsposition kurzfristig konstant hält. Im Folgenden wird zunächst die erste Möglichkeit betrachtet

Zur Kompensation eines, insbesondere durch eine höhere Vorschubgeschwindigkeit verursachten, Dosisverlustes kann die Lichtleistung erhöht werden. Dies erfordert eine größere, insbesondere instantane, Leistung von der Lichtquelle die häufig mit gesteigerten Kosten oder physikalisch-technischen Beschränkungen im Konflikt steht. Zur Lösung dieses Problems kann das De-Scanning als auch die dynamische Aufteilung der Leistung einer Lichtquelle auf mehrere Belichtungseinheiten als ökonomischere Variante dienen.

Beim De-Scanning wird die Relativbewegung der Bildpixel gegenüber dem Substrat minimiert und durch eine kurze, schnelle Ablenkung (Zeilensprung) unterbrochen. Dies kann aufgrund der geringen Sprungwege mit Hilfe von mechano-, elektro-, magneto- oder akustooptischer Ablenk- oder Verschiebeeinheiten erzeugt werden.

Beim der dynamischen Aufteilung einer Lichtquelle wird die Leistung der Lichtquelle dynamisch entweder zurückgehalten (z.B. cavity-dumped Laser, temperaturlimitierte Halbleiterlichtquellen) und zeitlich fokussiert, oder durch ein Verteilelement, wie z.B., einem rotierenden Polygonspiegel, elektrooptischen Schalter, oder dergleichen zeitlich zwischen den Verbrauchern aufgeteilt. Ziel ist es immer die Langzeitleistung konstant zu halten, die kurzfristige Leistung aber über das Abtastverhältnis zu erhöhen.]

### Integrierte Messoptik

Vorzugsweise weist die Vorrichtung eine, insbesondere im optischen System integrierte, Messoptik auf. Mit besonderem Vorzug wird ein Strahlteiler verwendet, um das von der zu belichtenden Schicht reflektierte Licht aus demselben optischen Pfad auszukoppeln, mit dem das DMD für die Belichtung beaufschlagt wird. Die Messoptik hat mehrere wichtige Aufgaben, die nicht alle gleichzeitig erfüllt sein müssen:
- Ausrichtung, um das Belichtungsfeld zu vorhandenen Strukturen am Substrat auszurichten oder neu zu formen,
- Kalibrierung und Überprüfung des Schreibkopfs,
- In-Situ Kontrolle des Schreibvorgangs,
- Echtzeitkorrektur bei dynamischen Veränderungen der relativen Bild-Substratlage.

Die Ausrichtung erfolgt entweder in Bezug zu bereits am Substrat aufgebrachten Ausrichtungsmarken oder, an bewusst aufgebrachten oder bereits vorhandenen Strukturen, die als Ausrichtungsmarken oder Passmarken (engl.: alignment marks) für die neu zu belichtenden Strukturen dienen. Dadurch wird es erfindungsgemäß möglich, große Flächen zu belichten, indem das optische System immer an den bereits belichteten Strukturen neu ausgerichtet und/oder kalibriert wird.

Ein weiterer wichtiger Aspekt einer erfindungsgemäßen Ausführungsform besteht darin, dass durch Vergleich der aktuell gemessenen Position der Passmarken mit den Sollpositionen eine etwaige, insbesondere durch Vorprozesse und/oder thermische Einflüsse verursachte, Verzerrung des Substrats berechnet wird und das zu schreibende Abbild an diese Verzerrung angepasst wird. Die können auch Verzerrungen höherer Ordnung sein.

Speziell bei der Vermeidung von Vernähungsartefakten (Fehler an Übergängen zwischen benachbarten Pixeln und/oder benachbarten Belichtungsrastern) spielt die Ausrichtung und/oder Echtzeitkorrektur eine wichtige Rolle.

Durch Erfassung der Strukturen (können auch oberflächentypisches Rauschen sein) des Belichtungsfeldes bei der Belichtung und einem Abgleich mit einer Erfassung benachbarter Belichtungsstrukturen kann über Korrelation oder ähnliche Verfahren ein Versatz des Substrates festgestellt werden. Dieser wird als Fehlersignal dem DMD-Bild beaufschlagt, womit eine Kompensation bis in den Subpixelbereich hin möglich ist.

Die Erfassung/Vermessung erfolgt vorzugsweise entlang desselben optischen Pfades, der auch zum Belichten verwendet wird, damit eine mechanische Verbindung, insbesondere Fixierung, während der Erfassung/Vermessung realisiert werden kann.

Zur Erfassung/Vermessung wird das Lichtsignal (Lichtstrahl der mindestens einen Lichtquelle) von der Oberfläche über ein optisches Element, vorzugsweise einen halbdurchlässigen Spiegel oder ein Prisma, ausgekoppelt und von einem entsprechenden Detektor aufgenommen. Der Detektor (oder ein daran angeschlossenes Auswertungssystem) ist dann in der Lage, die Oberfläche der zu strukturierenden Schicht zu überwachen, während sie belichtet/beschrieben wird. Bei dem Detektor handelt es sich vorzugsweise um eine Kamera, noch bevorzugter um eine CCD- oder CMOS-Kamera. Das Kamerabild kann ein oder mehrere Teile, einen größeren Bereich oder einen oder mehrere kleiner Teilbereiche des Bestrahlungsfeldes erfassen. Die Belichtung kann über eine eigene Lichtquelle verfügen und im gleichen (bevorzugt) oder in einem anderen Wellenlängenbereich der Bestrahlung erfolgen.

In einer besonderen erweiterten Ausführungsform existiert auch eine Vermessungsoptik auf der Unterseite der erfindungsgemäßen Ausführungsform, mit deren Hilfe man Ausrichtungsmarken an der Unterseite des Substrathalters oder des Substrates detektieren kann. Das Prinzip der Unterseitenvermessung eines Substrathalters ist ähnlich der Ausführungsform, welche in der Druckschrift PCT/EP2016/070289 offenbart wird. Die Vermessung von Ausrichtungsmarken an der Unterseite ermöglicht es, Strukturen auf beiden Seiten zu erstellen die zueinander ausgerichtet sind.

### Intensitätsverteilungsfunktionen

In einer ersten, besonders bevorzugten, erfindungsgemäßen Ausführungsform wird eine abbildende/sekundäre Optik (zur Beeinflussung, insbesondere Skalierung, der vom DMD reflektierten sekundären Belichtungsstrahlen) so ausgebildet, dass nicht eine scharfe Abbildung des DMD Spiegels in der Fokusebene erreicht wird, sondern eine absichtlich leicht unscharfe Abbildung, die auch benachbarte Bildpunkte mitbelichtet. Dadurch kann die Optik deutlich günstiger konstruiert werden und dennoch die Qualität der erzeugten Strukturen verbessert werden. Die Intensitätsverteilungsfunktionen (Intensitätsprofile) über den Durchmesser des Strahls können jeder beliebigen mathematischen Funktion entsprechen. Als Näherung zur komplexeren realen Verteilung werden geschlossene Formulierungen verwendet. Insbesondere denkbar sind vor allem:
- Gauß Verteilung,
- Lorentz Verteilung,
- Cauchy Verteilung,
- Konvolutionen unterschiedlicher Verteilungsfunktionen.

Das zu belichtende Material der lichtempfindlichen Schicht verfügt insbesondere über ein definiertes, vorzugsweise nichtlineares, Reaktionsverhalten, das primär der akkumulierten deponierten Lichtmenge und insbesondere sekundär der Leistung und damit dem Belichtungsverhalten entspricht. Es bildet sich deshalb bei einem örtlichen Belichtungsmengengradienten eine Belichtungskante zwischen hoher und niedriger Dosis aus, die innerhalb definierter oder definierbarer Grenzen schwanken kann. Das präsentierte Verfahren nutzt dieses Verhalten und erlaubt die Position dieser Belichtungsgrenze durch Überlappung mehrerer Belichtungsfelder (insbesondere bezogen auf die einzelnen Mikrospiegel) mit einer höheren Genauigkeit als der Pixelgröße steuern.

Für eine exakte Positionierung wird die Bestrahlungsleistung insbesondere vorausberechnet und auf mehrere Belichtungselemente (insbesondere Pixel) und/oder in unterschiedliche Belichtungsschritte zerlegt. Die Belichtungsschritte sind insbesondere zeitlich getrennt und/oder unterschiedlich lang und ergeben in Summe eine Zielbelichtungsverteilung auf Rasterebene (Rasterintensitätsprofil) und/oder auf Substratebene (Substratintensitätsprofil). Hierbei wird vorzugsweise die kohärente und/oder nicht-kohärente Überlappung der einzelnen Verteilungsfunktionen (Spiegelintensitätsprofile und/oder Rasterintensitätsprofile) und/oder eine Dynamik der Bildentstehung berücksichtigt.

Das Resultat ist eine Strukturierung der Belichtungsgrenze die primär als Summe der Belichtungsprozesse, aber sekundär im dynamischen Fall auch unter Berücksichtigung simulierter oder empirisch ermittelter Materialantworten in ihrer zweidimensionalen, aber auch der dreidimensionalen Form definiert wird. Im Folgenden werden die Begriffe Überlappung und Interferenz näher ausgeführt.

Die Mehrfachbelichtung einer individuellen Teilfläche kann sowohl gleichzeitig aber auch zeitverzögert erfolgen. Solange die Veränderungen im belichteten Material unabhängig von der Belichtungsleistung und rein abhängig von der Fluenz (akkumulierte Flächendosis) sind, sowie keine mechanischen Veränderungen (wie durch Erwärmung oder Versatz durch Vibrationen oder Verschiebungen) erfolgen, führen Überlappungen von Belichtungsfeldern über ein einfaches Aufaddieren zu den gleichen Ergebnissen wie ein nur von einer Lichtquelle belichtetes Feld.

In Fällen bei denen Nichtlinearitäten auftauchen, können diese durch entsprechende Kalkulationen oder Test und folgende Anpassungen der Teilbelichtungen ausgeglichen werden. Im Falle von stochastischen Schwankungen führen die Überlappungen zu ungewollten Unschärfen oder Fluktuationen, die als Bildfehler (z.B. als Unschärfe) auftauchen.

Bei reproduzierbaren oder vorausberechenbaren Überlappungen können Kantenrauheit, Sprünge und andere unerwünschte Effekte minimiert werden und ein sauberes Vernähen der Belichtungsfelder garantiert werden. Selbst kurzfristig auftauchende Fluktuationen der Belichtungsposition können durch das erfindungsgemäße Verfahren kompensiert werden.

Interferenzeffekte tauchen in der Optik bei gleichzeitiger Belichtung über mehrere Strahlwege auf, wenn die Teilstrahlungsquellen aufgrund ihrer Kohärenz das exakt oder fast gleiche zeitliche und räumliche Verhalten besitzen. Hier wird die Überlagerung der Felder elektromagnetischer Teilwellen nicht einfach gemittelt, sondern erzeugen auch in den - im Verhältnis zu den im THz-Bereich langsamen photoempfindlichen Flächen und Volumina - konstruktive und destruktive Überlagerungen. Am häufigsten tauchen diese Effekte bei Überlagerungen der Emission aus der gleichen Quelle auf, bei denen die Laufzeiten innerhalb der Kohärenzzeit ähnlich sind - das hochfrequente Schwingungsverhalten also voneinander abhängig bleibt. Bei Mehrfachbelichtungen können auch photochemische Interferenzeffekte auftauchen, bei denen die aufeinander folgenden Belichtungsschritte miteinander reagieren. Diese werden entsprechend in der Ansteuerung berücksichtigt.

### Vermeidung von Fehlbelichtungen bei hoher Geschwindigkeit

In einer zweiten verbesserten Ausführungsform wird eine Optimierung der Datenpfade durchgeführt. Ein fundamentales Problem beim, maskenlosen Belichtungsprozess besteht darin, dass sehr aufwendige und komplexe Berechnungen (z.B. Rasterisierung) durchgeführt werden und hierbei enorme Datenmengen gespeichert und übertragen. Die im Computer gespeicherten Daten werden mit der Relativbewegung zwischen optischem System und der zu belichtenden Schicht beziehungsweise der DMD mit dem Substrat synchronisiert. Die in/auf der zu belichtenden Schicht abzubildenden Strukturdaten sind in einem Computer gespeichert. Die Strukturdaten definieren, wie die Spiegel des DMD als Funktion des Ortes geschaltet werden, um den Belichtungsstrahl so zu verändern, dass das gewünschte Muster auf die zu belichtende Schicht fällt. Im Falle einer vollflächigen oder steppenden Ausführungsform befinden sich das optische System und damit das DMD immer an einer definierten, insbesondere fixierten, Position. Es ist daher in diesem Fall nicht nötig, eine dynamische Korrelation zwischen der Position und den Strukturdaten herzustellen.

Wird allerdings eine (bevorzugte) scannende Ausführungsform verwendet, so findet eine kontinuierliche Belichtung als Funktion des Ortes statt, bei der das DMD während der Relativbewegung kontinuierlich mit neuen Daten versorgt werden, um die Mikrospiegel als Funktion des Ortes zu steuern. Die Daten für die Spiegelschaltung müssen daher schnell genug an das DMD gesendet werden. Da die Berechnung der Spiegelmatrix aufwendig ist, werden gemäß einer vorteilhaften Ausführungsform verschiedene Berechnungen aufgeteilt. Es wird insbesondere zwischen zeitkritischen und zeitunkritischen Berechnungen unterschieden.

Unter zeitkritischen Berechnungen werden erfindungsgemäß alle Berechnungen verstanden, die so schnell durchgeführt werden müssen, dass die Daten das DMD erreichen, bevor es seine Relativposition in Bezug zur zu belichtenden Schicht verändert hat.

Die zeitkritischen Berechnungen sind insbesondere
- Abbildberechnung, insbesondere
   ∘ DMD Ansteuerung
- Sensormessungen und Feedbackberechnungen, insbesondere
   ∘ Abtastung und Anpassungen an die aktuelle Schreibposition
- Dekomprimierung
   ∘ Insbesondere von Daten des DMDs und/oder an das DMD

Diese Berechnungen verlangen relativ hohe Berechnungsgeschwindigkeiten, sodass eine Hardwareberechnung einer Softwareberechnung bevorzugt wird. Mögliche Hardwarekomponenten zur Berechnung sind
- FPGA (field programmable grid array)
- ASIC (Application Specific lntergrated Circiut)
- GPU (Graphics Processing Unit)
- Signalprozessor (DSP - digital signal processor)

Die zeitunkritischen Berechnungen sind solche, die sich während dem Belichtungsprozess nur wenig verändern oder ablaufunkritisch sind, insbesondere
- Konvertierung der Vektordaten in Pixeldaten (Rasterisierung),
- Anpassungen der Strukturgröße
- großflächige Verzerrungskompensation
- Einfügen von Wafer- oder Die-spezifischen Daten (z.B. Seriennummern)
- Zerschneiden der Daten in Streifen für einen einzelnen Schreibkopf
- Rasterung der Vektordaten

Diese Berechnungen sind üblicherweise sehr komplex, umfassen in einem Rechenschritt sehr große Datenbereiche (insbesondere globale Anpassungen) und/oder können nicht besonders effizient durch Hardware durchgeführt werden. Sinnvollerweise werden diese Berechnungen parallelisiert
- in mindestens einem Thread desselben Computers oder
- in mindestens einem Thread mindestens eines weiteren Computers durchgeführt. Die Threads können dabei die Ressourcen der CPUs und/oder der GPUs der Grafikkarten verwenden.

Die Kommunikation zwischen dem Computer und den DMDs erfolgt über eine beliebige Schnittstelle, insbesondere
- Kabelbehaftete Kommunikation
   ∘ USB,
   ∘ Ethernet,
   ∘ DisplayPort.

Eine erste verbesserte Ausführungsform beruht darauf, dass in der Hardware für zeitkritische Berechnungen ein Speicher zur Verfügung steht, der so groß ist, dass mindestens zwei zu belichtende Abschnitte der zu belichtenden Schicht (insbesondere Teilabschnitte der Belichtungspfade, vorzugsweise Streifen, noch bevorzugter parallele Streifen) dort abgelegt und gespeichert werden können. Während ein zu belichtender Abschnitt aus dem Puffer/Speicher geschrieben wird, wird der zweite zu belichtende Abschnitt vom Computer an die Einheit zur Berechnung der zeitkritischen Aufgaben übertragen. Der Belichtungsvorgang eines zu belichtenden Abschnitts beginnt erst, wenn dieser vollständig im Speicher vorhanden ist. In der Regel ist der zweite Streifen schon vollständig in den Speicher geladen, bevor der der erste Streifen seinen Belichtungsvorgang abgeschlossen hat. Dieses Prinzip wird für die nachfolgenden Streifen wiederholt. Es wird effektiv verhindert, dass innerhalb eines Belichtungsstreifens keine Daten mehr für die zeitkritische Berechnung zur Verfügung stehen und es zu Fehlbelichtungen kommt.

### Echtzeitkorrektur der Schreibdaten

In einer dritten verbesserten Ausführungsform erfolgt eine, zumindest teilweise, Kompensation mechanischer Fehler durch optische Elemente. Soll die erfindungsgemäße Anlage in einem scannenden Prozess eine kontinuierliche Struktur in die zu belichtende Schicht belichten, so ist es vorteilhaft, die Positionierungsgenauigkeit des Substrathalters besser einzustellen oder vorzusehen als der Overlay. Etwaige Positionsfehler haben ihren Ursprung in nicht perfekt gefertigten mechanischen Bauteilen, Spielen und Toleranzen, einer nicht perfekten Motorsteuerung etc. Es ist relativ aufwendig, durch mechanische Mittel den Positionsfehler zu verkleinern. Gemäß der erfindungsgemäßen Ausführung ist es nun möglich, größere Positionsfehler als den Overlay zuzulassen. Dabei wird der Positionierfehler messtechnisch erfasst und das DMD-Bild entsprechend, insbesondere in Echtzeit, versetzt.Der Positionsfehler wird erfindungsgemäß derart kompensiert dass dieser zu jedem Zeitpunkt des Belichtungsvorgangs kleiner ist als die Overlay Spezifikation. Das Verhältnis zwischen dem Overlay und dem unkorrigierten Positionsfehler ist insbesondere kleiner als 1, vorzugsweise kleiner als 10, noch bevorzugter kleiner als 100.

Erfindungsgemäß können Fehler normal zur Richtung der Relativbewegung und in Richtung der Relativbewegung kompensiert werden.

Bei Fehlern normal zur Richtung der Relativbewegung wird ein etwas schmälerer Belichtungsstreifen verwendet, obwohl das DMD für die Belichtung eines breiteren Belichtungsstreifens ausgelegt ist. Die zusätzlichen Belichtungsbereiche links und rechts dienen somit als Puffer. Bei Positionsabweichungen des Substrathalters wird der Belichtungsstreifen in Echtzeit nach links beziehungsweise rechts verschoben sodass trotz eines Positionsfehlers die Daten an die richtige Stelle der zu belichtenden Schicht belichtet werden.

Fehler in Richtung der Relativbewegung werden analog kompensiert. Bewegt sich der Substrathalter zu langsam, wird insbesondere die Scrolling-Geschwindigkeit (Zeilentakt) angepasst und die Intensität durch die Belichtungssteuerung kompensiert. Bewegt sich der Substrathalter zu schnell, kann die Position des Belichtungsbildes auch durch die Scrolling-Geschwindigkeit (Zeilentakt) angepasst werden, eine Korrektur der Dosis durch Anpassung der Belichtungszeit ist aber nur möglich, wenn nicht mit maximaler Intensität belichtet wird.

Die Erfindung ermöglicht den Einsatz von kostengünstiger Mechanik und erreicht trotzdem eine hohe Positionierungsgenauigkeit.

### Streifenüberblendung (Stitching)

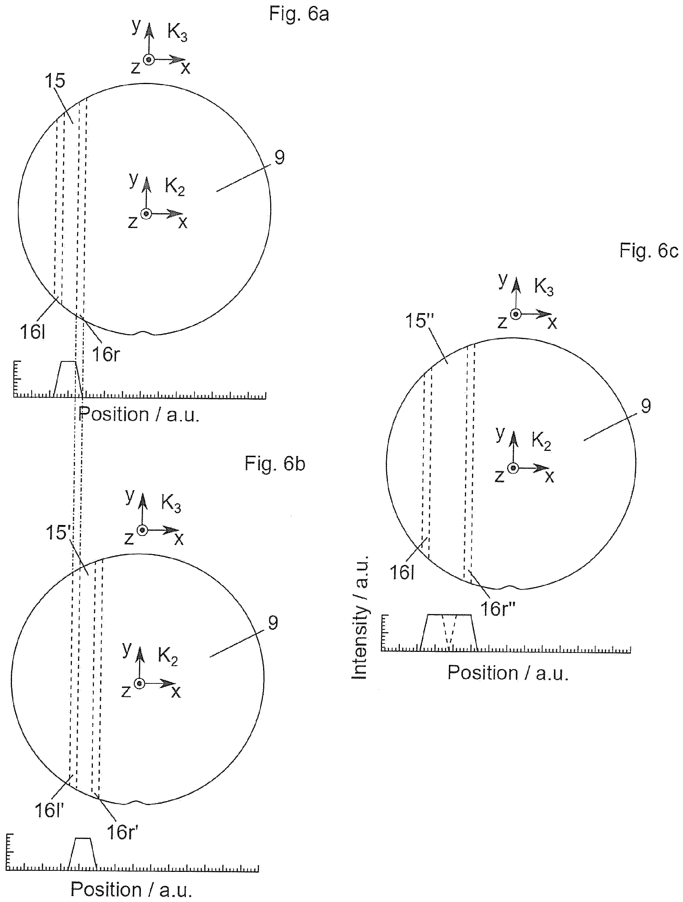

In einer vierten verbesserten Ausführungsform wird die zu belichtende Schicht so belichtet, dass die berechneten Belichtungsabschnitte (insbesondere Streifen) überlagert werden. Vorzugsweise werden Bereiche am Rand der Streifen doppelt belichtet. Um eine Über- beziehungsweise Unterbelichtung zu vermeiden, wird die Intensität als Funktion der Position des optischen Systems, insbesondere des DMDs, variiert oder variierbar ausgebildet. Vorzugsweise addieren sich dann die Intensitätsprofile zu einem konstanten oder zumindest homogeneren Intensitätsprofil. Die Überlagerung der Streifen kann man als Nahtstellen ansehen, die so belichtet werden sollen, dass, im Idealfall, kein Unterschied zu einer vollflächigen Belichtung erkennbar ist. Eine genauere Beschreibung erfolgt in der Figurenbeschreibung der Figuren 6a-c. Die erfindungsgemäße Streifenüberlagerung kann nicht nur dadurch erzeugt werden, dass der Abfall der Intensität am Rand eines Belichtungsstreifens ausgenutzt wird, sondern dass gezielt eine dynamische Beleuchtungssteuerung verwendet wird, welche die Intensität in den Randbereichen des Belichtungsstreifens kontinuierlich abnehmen lässt. Dadurch wird es erfindungsgemäß besonders bevorzugt ermöglicht, die Nahtstellen durch gezielte Intensitätssteuerung zu kontrollieren.

### Descanning

In einer fünften verbesserten Ausführungsform erfolgt der Belichtungsvorgang derart, dass in einem ersten Schritt das optische System oder das DMD und das Substrat in dieselbe Richtung, insbesondere synchron, noch bevorzugter simultan, verfahren und optional in diesem Prozessschritt die Lichtquelle eingeschaltet wird. In einem folgenden, zweiten Prozessschritt wird das optische System (oder das DMD) in die zur Bewegungsrichtung des Substrathalters entgegengesetzte Richtung mit bevorzugt deutlich höherer Geschwindigkeit verschoben. Insbesondere findet in diesem Prozessschritt keine Belichtung statt. Die gleichzeitige Bewegung gefolgt von der teilweisen Rückbewegung des optischen Systems wird danach entlang der gesamten Zeile, insbesondere für jede weitere DMD-Zeile durchgeführt. Durch die synchrone, insbesondere kollineare, Relativbewegung des optischen Systems und des Substrats wird eine quasistatische Belichtung erzeugt. Hierdurch wird die Verwaschung der Belichtung durch die Relativbewegung beim Scannen reduziert, vorzugsweise gänzlich unterbunden, und es kann eine bessere Abbildung erzielt werden.

In einer weiteren verbesserten Ausführungsform erfolgt der Belichtungsvorgang derart, dass in einem ersten Schritt eine Relativbewegung zwischen dem optischen System und der zu belichtenden Schicht in einer ersten Richtung erfolgt. In einem insbesondere simultan ablaufenden, zweiten Prozessschritt wird das optische System (oder das DMD) in eine, von der ersten Richtung abweichenden, insbesondere normal zur ersten Richtung angeordneten, zweiten Richtung verschoben. Vorzugsweise findet diese Verschiebung in kleineren Schritten als die Abbildungsbreite eines einzelnen Bildpunktes (Pixel) statt, wodurch sich ein deutlich feineres Positionierungsraster der Abbildungspunkte ergibt. Die gleichzeitige Bewegung gefolgt von der seitlichen Bewegung des optischen Systems erlaubt ebenfalls eine Erhöhung der Positioniergenauigkeit beziehungsweise des Overlays. Durch die synchrone, insbesondere nicht kollineare, Relativbewegung von optischem System und Substrat wird die Verwaschung der Belichtung durch die Relativbewegung beim Scannen reduziert, vorzugsweise gänzlich unterbunden, und es kann eine bessere Abbildung erzielt werden.

In der erfindungsgemäßen Ausführungsform können alle Elemente, welche der Bilderzeugung dienen, insbesondere die optischen Elemente, mittels Piezoelementen verstellt werden. Insbesondere können elektro-/akusto/mechanooptische Elemente verwendet werden. Durch die Ansteuerung wird das Bild in die x- und/oder y- und/oder z-Richtung verschoben. Es können auch mehrere Elemente verwendet werden, die insbesondere translatorische und/oder rotatorische Bewegungen des Bildes durchführen können. Das Bild kann mit einer der Scangeschwindigkeit entsprechenden Geschwindigkeit nachgeführt werden.

### Simultane Belichtung unterschiedlicher Strukturen auf unterschiedlichen Fokusebenen.

In einer sechsten verbesserten und bevorzugten Ausführungsform wird die Fokusebene gegenüber der zu belichtenden Schicht gekippt. Bei einer Belichtung sind die Position der Fokusebene und die Tiefenschärfe von fundamentaler Bedeutung für die Qualität der abgebildeten Struktur. Die Fokusebene kann auf mehrere Arten gekippt werden.

In einer ersten Weiterbildung der sechsten Ausführungsform wird die Fokusebene durch mechanisches Kippen des gesamten DMDs verändert. Diese Ausführungsform ist die am wenigsten bevorzugteste.

In einer zweiten, bevorzugteren Weiterbildung der sechsten Ausführungsform wird die Fokusebene durch eine gezielte Änderung optischer Elemente beeinflusst, die dem DMD vor und/oder nachgeschaltet sind. Das Kippen der Fokusebene wird durch optische Elemente bewerkstelligt. Vorzugsweise wird die Fokusebene statisch einmal eingestellt und die unterschiedlichen Bereiche vom DMD verwendet, um unterschiedliche Tiefen in der zu belichtenden Schicht zu belichten.

In einer dritten erfindungsgemäßen Weiterbildung der sechsten Ausführungsform werden mehrere Lichtquellen unterschiedlicher Wellenlängen und/oder Lichtquellen mit einem breiten Wellenlängenspektrum eingesetzt, um mehrere, insbesondere kontinuierliche, Fokusebenen in der zu belichtenden Schicht (beziehungsweise durch die zu belichtende Schicht hindurch) zu erzeugen.

Die zu belichtende Schicht wird bei dieser Ausführungsform vorzugsweise aus einem Material, insbesondere Polymer, gebildet, welches über den gesamten Wellenlängenbereich sensitiv für die entsprechende Strahlung ist.

### Dynamische Belichtungssteuerung für die Graustufenlithographie

In einer siebten, verbesserten Ausführungsform wird die Intensität an jeder Position durch eines der folgenden Verfahren gezielt gesteuert. Dadurch können Über- und/oder Unterbelichtungen ausgeglichen werden. Weiterhin können Strukturen minderer Qualität nachgebessert werden oder Belichtungsgradienten erzeugt werden. Durch die gezielte Steuerung der Intensität an jeder Position können insbesondere
- 3D Strukturen
- Graustufenlithographie und/oder
- Optical proximity correction
erzeugt werden.

Ein fundamental wichtiger Aspekt bei der Verwendung von DMDs besteht darin, dass die Intensität der Photonen, die auf die zu belichtende Schicht treffen, räumlich korrekt verteilt wird. Da keine Lichtquelle einen idealen Punktstrahler darstellt, besitzt auch keine Lichtquelle eine homogene Intensitätsverteilung. Dementsprechend ist auch der Lichtstrahl, der auf das DMD trifft, inhomogen. Vorzugsweise wird dieser Lichtstrahl vor dem Auftreffen auf das DMD durch optische Elemente im optischen System homogenisiert.

Erfindungsgemäß bevorzugt wird nicht nur die Homogenität der Lichtquelle modifiziert, sondern das DMD (insbesondere dessen Mikrospiegel) auf einen reflektierten Strahl mit korrekter Intensitätsverteilung auf die zu belichtende Schicht eingestellt. Um eine derartige komplexe, räumliche Intensitätsverteilung korrekt zu steuern, gibt es mehrere vorteilhafte technische Maßnahmen.

Die Leistung der Lichtquelle liegt insbesondere zwischen 0.01 Watt und 1000 Watt, vorzugsweise zwischen 0.1 Watt und 500 Watt, noch bevorzugter zwischen 1 Watt und 250 Watt, am bevorzugtesten zwischen 5 Watt und 100 Watt, am allerbevorzugtesten zwischen 9 und 13 Watt.

Die Intensität wird in W/m² angegeben. Durch die Bündelung der Strahlung mittels optischer Elemente auf eine Einheitsfläche kann die Intensität entsprechend einfach kalkuliert werden. Die Intensität der Lichtquelle kann vorzugsweise sehr genau geregelt werden. Die Intensität wird entweder durch die Veränderung der Leistung der Lichtquelle, durch die Dauer der Belichtung und/oder durch optische Elemente im optischen System verändert. Dadurch wird es erfindungsgemäß möglich, Lichtstrahlen unterschiedlicher Intensität innerhalb eines wohldefinierten Zeitraums auf das DMD einzustrahlen. Durch eine entsprechende Spiegelsteuerung können so einzelne Punkte der zu belichtenden Schicht mit definierten Intensitäten bestrahlt werden. Die umliegenden Punkte der zu belichtenden Schicht können mit einer davon unterschiedlichen Intensität beleuchtet werden.

Erfindungsgemäß wird insbesondere die Möglichkeit der gezielten, punktförmig (insbesondere auf einzelne Pixel bezogene) aufgelösten Belichtung der zu belichtenden Schicht. Durch eine Relativbewegung zwischen dem optischen System und der zu belichtenden Schicht kann jede Position mehrmals angefahren werden, wodurch jeder zu belichtende Bildpunkt mehrfach belichtet werden kann. Durch eine Vermessung mittels eines Messsystems und gezielte Analyse der Qualität der Oberfläche kann die Mehrfachbelichtung derart gesteuert werden, dass eine optimal homogene Belichtung bis unter die Pixelebene erreicht werden kann.

Somit können einerseits Intensitätsinhomogenitäten aus dem Primärstrahl kompensiert werden, sofern eine homogene Bildpunktbelichtung erwünscht ist, andererseits es können ortsbezogen unterschiedliche Belichtungsdosen in die zu belichtende Schicht eingebracht werden.

Durch die genannten erfindungsgemäßen Ausführungsformen ist es weiterhin möglich, die zu belichtenden Belichtungsabschnitte (insbesondere Streifen) zu überlappen. Durch eine Überlappung werden einzelne Bildpunkte mehrmals belichtet. Ausgehend von der Anzahl der Belichtungen pro Bildpunkt kann für jeden einzelnen Belichtungsvorgang der gewünschte Intensitätsanteil berechnet werden, mit dem der Bildpunkt belichtet wird.

Soweit Strukturen mit einem Intensitätsgradienten abgebildet werden sollen, wird erfindungsgemäß insbesondere festgelegt, wie oft ein Bildpunkt mit welcher Intensität belichtet werden soll, damit jeder Bildpunkt bei n-maliger Wiederholung am Ende des Belichtungsprozesses mit der festgelegten absoluten Intensität beaufschlagt wurde.

### Anisotrop und oder verzerrte Abbildungsoptik zur Verbesserung des Overlay-Fehlers und/oder der Bewegungsunschärfe

In einer weiteren, achten erfindungsgemäßen Ausführungsform werden horizontale und/oder vertikale Belichtungsrastergitterlinien des Belichtungsrasters durch die optische Abbildung unterschiedlich abgebildet (also insbesondere nicht quadratisch), sodass eine unterschiedliche Belichtungsrasterauflösung in vertikaler und horizontaler Richtung eingestellt wird. Die Berechnung/Steuerung der Belichtung wird um die Abweichung kompensiert.

In einer weiteren Ausführungsform werden die Achsen der Abbildung beziehungsweise die Belichtungsrastergitterlinien nicht orthogonal, sondern schräg verlaufend angeordnet. Der Einsatz einer solchen, insbesondere affin verzerrten, Projektion (insbesondere einer Scherung) ermöglicht eine einfache Berechnung der Bestrahlungspositionen und eine lineare Führung unter präziser Platzierung der Beleuchtungspunkte unterhalb der Rasterauflösung (Subpixelgenauigkeit) zur hochgenauen Formung der Belichtungskanten.

In weiteren erfindungsgemäßen Ausführungsformen werden die horizontalen und/oder die vertikalen Belichtungsrastergitterlinien des Belichtungsrasters entlang der vertikalen und/oder horizontalen Richtung nicht äquidistant ausgeführt.

Die unterschiedlichen Belichtungsraster können durch die dem DMD vor- und/oder nachgeschalteten optischen Elemente aus einem homogen isotropen Bild des DMDs erzeugt werden und/oder sind ein direktes Resultat eines anisotrop und/oder inhomogen konstruierten DMDs.

Im weiteren Verlauf werden einige Möglichkeiten aufgezeigt, um eine entsprechende erfindungsgemäße Projektion, insbesondere Scherung des Belichtungsrasters zu erzeugen.

In einer ersten erfindungsgemäßen möglichen Ausführungsform wird mindestens eine Zylinderlinse mit einer Zylinderachse als Abbildungsoptik verwendet, um eine Veränderung des Belichtungsrasters zu bewirken. Insbesondere werden genau zwei Zylinderlinsen verwendet. Die Zylinderachsen der Zylinderlinsen liegen vorzugsweise parallel zur zu belichtenden Oberfläche. Um eine erfindungsgemäße Scherung zu erzielen, wird zwischen den beiden Zylinderachsen ein Winkel kleiner als 90°, vorzugsweise kleiner als 70°, noch bevorzugter kleiner als 50°, am bevorzugtesten kleiner als 20° eingestellt. Der allerbevorzugteste Winkel ergibt sich allerdings aus dem zu erzeugenden Scherwinkel.

In einer weiteren erfindungsgemäßen Ausführungsform besteht das optische System aus nur einer einzigen sogenannten Verbundlinse. Unter einer Verbundlinse versteht man eine Linse, deren Oberflächen so geschliffen wurden, dass die optischen Eigenschaften identisch zu jenen optischen Eigenschaften sind, die man durch Kombination zweier Linsen erhalten würde.

Die oben angegebenen Ausführungsformen lassen sich sowohl mit einem regelmäßigen, aber auch unregelmäßigen Bestrahlen des Substrates erreichen. Im Spezialfall einer regelmäßigen, aber nicht exakt ganzzahlig zu der Verfahrgeschwindigkeit passenden Wiederholrate der Belichtung werden die Belichtungsstrukturen weiterhin exakt zur aktuellen Schreibposition aktiviert. Entsprechend ergeben sich nichtganzzahlige Versätze zu Subpixel-Platzierungen in Verfahrrichtung, die in einer verbesserten Platzierungsgenauigkeit und auch Kantenrauheit resultieren.

Eine Kombination der oben beschriebenen geometrischen und/oder zeitlichen Verschiebungen erzeugt eine Sub-Pixel-Auflösung in allen Richtungen und verringert die Fehleranfälligkeit gegenüber Ausfällen einzelner Belichtungskomponenten. Um die korrekte Belichtungsdosisverteilung zu charakterisieren, ist die Kenntnis von durch Abbildungsfehler und/oder künstlich hervorgerufenen Verzerrungen erforderlich. Linear verzerrte oder verdrehte Abbildungen haben den Vorteil einfacherer Berechnung sowie einer einfacheren Lichtquellensteuerung.

### Reduktion der Bewegungsunschärfe

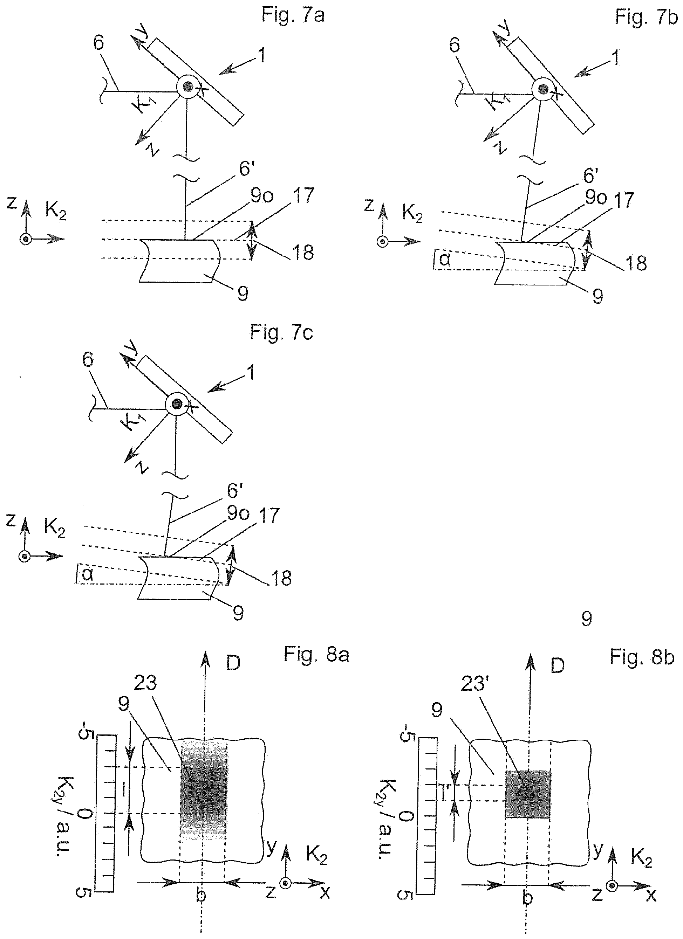

In einer weiteren, neunten erfindungsgemäßen Ausführungsform wird die Relativgeschwindigkeit und/oder -bewegung zwischen dem optischen System und der zu belichtenden Schicht so verändert, dass mehrere Pixel innerhalb einer Pixelgröße überlagern. Die Überlagerung kann als eine Langzeitbelichtung eines bewegten Objektes interpretiert werden. Dadurch kommt es zu einer Verwaschung des erzeugten Pixels in Relativbewegungsrichtung. Durch die Festlegung, wann einer der Pixel geschrieben bzw. nicht geschrieben wird, kann die Pixelgröße in Relativbewegungsrichtung gezielt eingestellt werden. Zur Veranschaulichung siehe die Figuren 8a-b bzw. die entsprechende Figurenbeschreibung.

Mit anderen Worten werden zwei sequentiell hintereinander beleuchtete Belichtungsraster mit einer relativen Verschiebung zwischen der Mikrospiegeleinrichtung und der lichtempfindlichen Schicht um weniger als eine Pixelbreite/Bildpunktbreite, vorzugsweise weniger als eine halbe Pixelbreite/Bildpunktbreite, noch bevorzugter weniger als eine Viertel Pixelbreite/Bildpunktbreite, der Pixel/Bildpunkte verschoben/bewegt.

Wenn die Verkleinerung oder Vergrößerung der Optik in Richtung der Scanbewegung deutlich geringer gewählt wird als in die der dazu orthogonalen Richtung kann der Effekt der aufgrund der endlichen Belichtungszeit entstehenden Bewegungsunschärfe zum Teil ausgeglichen werden. Dies ermöglicht es, eine isotrope Abbildung zu erreichen. Das Stauchen in Bewegungsrichtung reduziert nicht die Bewegungsunschärfe selbst, sondern nur die Gesamtausdehnung des Belichtungsflecks in Verfahrrichtung.

Alle genannten erfindungsgemäßen Ausführungsformen und Prozesse können beliebig miteinander kombiniert werden, werden aber einzeln beschrieben. Soweit Verfahrensmerkmale beschrieben sind, sollen diese auch als Vorrichtungsmerkmale offenbart gelten und umgekehrt.

Weitere Vorteile, Merkmale und Einzelheiten der Erfindung ergeben sich aus der nachfolgenden Beschreibung bevorzugter Ausführungsbeispiele sowie anhand der Zeichnungen. Die zeigen in:
- Figur 1: eine erste Ausführungsform der erfindungsgemäßen Vorrichtung,
- Figur 2: eine zweite Ausführungsform der erfindungsgemäßen Vorrichtung,
- Figur 3: eine dritte Ausführungsform der erfindungsgemäßen Vorrichtung,
- Figur 4a: eine schematische, nicht maßstabsgetreue Darstellung eines DMD (Mikrospiegeleinrichtung) mit einem vergrößerten Teilabschnitt mit Mikrospiegeln in einer ersten Position,
- Figur 4b: eine schematische, nicht maßstabsgetreue Darstellung eines DMD (Mikrospiegeleinrichtung) mit einem vergrößerten Teilabschnitt mit Mikrospiegeln in einer zweiten Position,
- Figur 5a: eine schematische, nicht maßstabsgetreue Darstellung einer Aufsicht auf einen ersten belichteten Abschnitt einer zu belichtenden Schicht,
- Figur 5b: eine schematische, nicht maßstabsgetreue Darstellung einer Aufsicht auf einen zweiten, gegenüber dem ersten leichtversetzten, belichteten Abschnitt der zu belichtenden Schicht,
- Figur 6a: eine schematische, nicht maßstabsgetreue Darstellung einer Aufsicht auf ein Substrat mit einem ersten belichteten Abschnitt,
- Figur 6b: eine schematische, nicht maßstabsgetreue Darstellung einer Aufsicht auf ein Substrat mit einem zweiten belichteten Abschnitt,
- Figur 6c: eine schematische, nicht maßstabsgetreue Darstellung einer Aufsicht auf ein Substrat mit dem überlagerten ersten und zweiten belichteten Abschnitt,
- Figur 7a: eine schematische, nicht maßstabsgetreue Darstellung einer weiteren Ausführungsform der erfindungsgemäßen Vorrichtung,
- Figur 7b: eine schematische, nicht maßstabsgetreue Darstellung einer weiteren Ausführungsform der erfindungsgemäßen Vorrichtung,
- Figur 7c: eine schematische, nicht maßstabsgetreue Darstellung einer weiteren Ausführungsform der erfindungsgemäßen Vorrichtung,
- Figur 8a: eine schematische, nicht maßstabsgetreue Darstellung einer Aufsicht auf einen weiteren belichteten Abschnitt einer zu belichtenden Schicht gemäß einer ersten Ausführungsform des erfindungsgemäßen Verfahrens,
- Figur 8b: eine schematische, nicht maßstabsgetreue Darstellung einer Aufsicht auf einen weiteren belichteten Abschnitt einer zu belichtenden Schicht gemäß einer zweiten Ausführungsform des erfindungsgemäßen Verfahrens,
- Figur 9a: schematische, nicht maßstabsgetreue, vergrößerte Ansicht einer ersten Ausführungsform eines erfindungsgemäßen Belichtungsrasters,
- Figur 9b: schematische, nicht maßstabsgetreue, vergrößerte Ansicht einer ersten Ausführungsform eines erfindungsgemäßen Belichtungsrasters,
- Figur 10: eine schematische Ansicht einer Intensitätsverteilung zweier nebeneinanderliegender Pixel mit drei unterschiedlichen Intensitätsstärken,
- Figur 11: eine schematische Ansicht eines Belichtungsrasters mit mehreren belichteten Pixeln und
- Figur 12: eine schematische Ansicht eines durch optische Elemente verzerrten Belichtungsrasters.

In den Figuren sind gleiche Bauteile oder Bauteile mit der gleichen Funktion mit den gleichen Bezugszeichen gekennzeichnet.

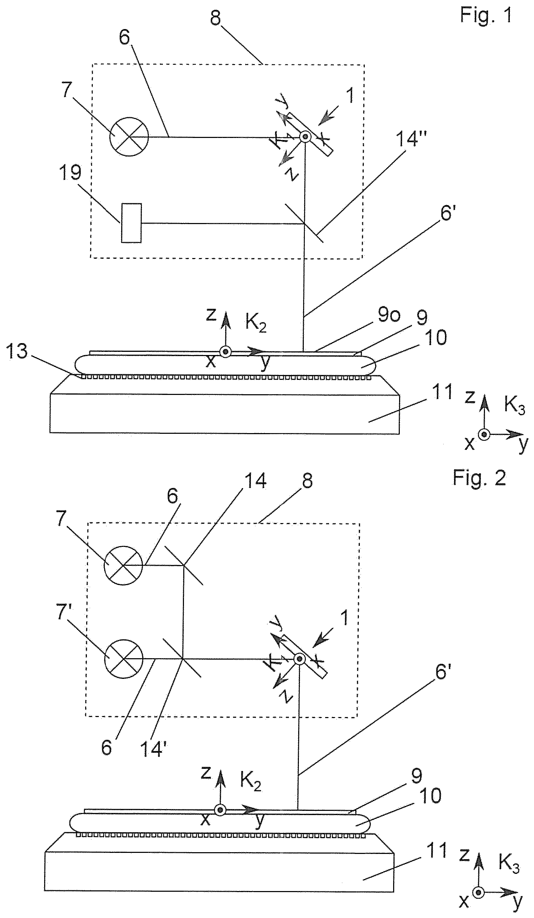

**Figur 1** zeigt eine erste Ausführungsform, bestehend aus einem optischen System 8, mit mindestens einer Lichtquelle 7 und mindestens einem DMD 1 (Mikrospiegeleinrichtung), einem Substrathalter 11. Der Substrathalter 11 kann in Bezug zu einem Koordinatensystem K3 bewegt werden.

Auf dem Substrathalter 11 wird mit Fixiermitteln 13 ein Substrat 10 fixiert, auf dem sich eine lichtempfindliche Schicht 9 aus einem belichtbaren Material befindet, die mittels der Vorrichtung belichtet wird.

Der Koordinatenursprung eines probenfesten (also auf das Substrat 10 beziehungsweise die zu belichtende Schicht 9 fixe) Koordinatensystems K2 wird vorzugsweise ins Zentrum der Oberfläche 9o der Schicht 9 gelegt.

Ein Lichtstrahl 6 (primärer Lichtstrahl), der von der Lichtquelle 7 emittiert wird, und auf dem Weg zum DMD 1 mehrere optische Elemente (nicht eingezeichnet) passieren kann, wird vom DMD 1 in einen strukturierten Lichtstrahl 6' (sekundärer Lichtstrahl) umgewandelt. Dieser kann auf dem Weg zur Schicht 9 mehrere optische Elemente (nicht eingezeichnet) passieren.

Mittels eines halbdurchlässigen Spiegels 14" kann ein Detektor 19, insbesondere eine Kamera, noch bevorzugter eine CCD- oder CMOS-Kamera, die Oberfläche 9o der zu belichtenden Schicht 9 direkt erfassen und/oder vermessen. Die Messergebnisse werden vorzugsweise zur unmittelbaren Steuerung des Verfahrens und/oder Kalibrierung der Vorrichtung eingesetzt. Auf die Darstellung derartiger Messmittel wird in den weiteren Figurenbeschreibungen und Figuren der Übersichtlichkeit halber verzichtet. Die erfindungsgemäßen Messmittel können aber in jeder genannten erfindungsgemäßen Ausführungsform verwendet werden.

**Figur 2** zeigt eine zweite Ausführungsform, wobei das optische System 8 hier mit zwei Lichtquellen 7, 7' ausgestattet ist. Lichtstrahlen 6 werden von den beiden Lichtquellen 7, 7' emittiert. Einer der Lichtstrahlen 6 wird durch einen Spiegel 14 auf einen Strahlteiler 14' umgeleitet und durch diesen mit dem Lichtstrahl 6 der zweiten Lichtquelle 7' vereint.

Der vereinte Lichtstrahl 6 wird auf das DMD 1 geleitet und von diesem in einen strukturierten Lichtstrahl 6' umgewandelt, der wiederum auf dem Weg zur Schicht 9 mehrere optische Elemente (nicht eingezeichnet) passieren kann.

Ein, insbesondere eigenständiger, erfindungsgemäßer Aspekt besteht hierbei vor allem darin, dass die beiden Lichtquellen 7 sich in Strahlungsintensität, Wellenlänge, Kohärenzlänge und gegebenenfalls weiteren Eigenschaften oder Parametern unterscheiden können, sodass ein Laserstrahl 6 mit einer Vielzahl unterschiedlicher optischer Parameter erzeugt werden kann.

Erfindungsgemäß können insbesondere mehr als 2, insbesondere mehr als 5, noch bevorzugter mehr als 10, am allerbevorzugtesten mehr als 20 Lichtquellen 7, 7' verwendet werden. Bei jeder Lichtquelle kann es sich vorzugsweise auch um ein LED-Feld oder LD(engl.: laser diode)-Feld handeln.

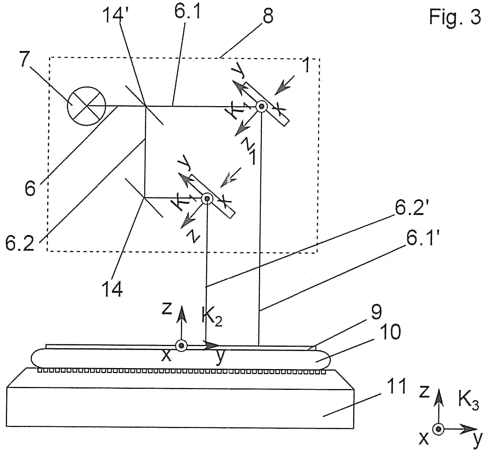

**Figur 3** zeigt eine dritte Ausführungsform, bestehend aus einem optischen System 8 mit mindestens einer Lichtquelle 7 und zwei DMDs 1.

Ein Lichtstrahl 6 wird von der Lichtquelle 7 emittiert und durch einen Strahlteiler 14' geteilt. Ein erster geteilter Lichtstrahl 6.1 wird von einem ersten DMD 1 zu einem ersten modifizierten Strahl 6.1' modifiziert. Mit dem ersten modifizierten Strahl 6.1' wird die Schicht 9 belichtet. Der zweite geteilte Lichtstrahl 6.2 wird mittels eines Spiegels 14 auf ein zweites DMD 1 umgeleitet und als zweiter modifizierter Strahl 6.2' auf die Schicht 9 weitergeleitet. Vorzugsweise wird mit dem zweiten modifizierten Strahl 6.2' eine andere Position der zu belichtenden Schicht 9 belichtet als mit dem ersten modifizierten Lichtstrahl 6.1'. Alle genannten Lichtstrahlen können dabei mehrere optische Elemente (nicht eingezeichnet) passieren.

Ein, insbesondere eigenständiger, erfindungsgemäßer Aspekt besteht hierbei darin, dass mindestens zwei DMDs 1 verwendet werden, mittels derer gleichzeitig an zwei verschiedenen Positionen der Schicht 9 belichtet werden kann, wobei vorzugsweise ein einziger, insbesondere vereinter, Lichtstrahl für die Beaufschlagung der DMDs verwendet wird. Dies führt insbesondere zu einer Verbreiterung des Belichtungsabschnitts, insbesondere Belichtungsstreifens, und damit in einer Erhöhung des Durchsatzes.

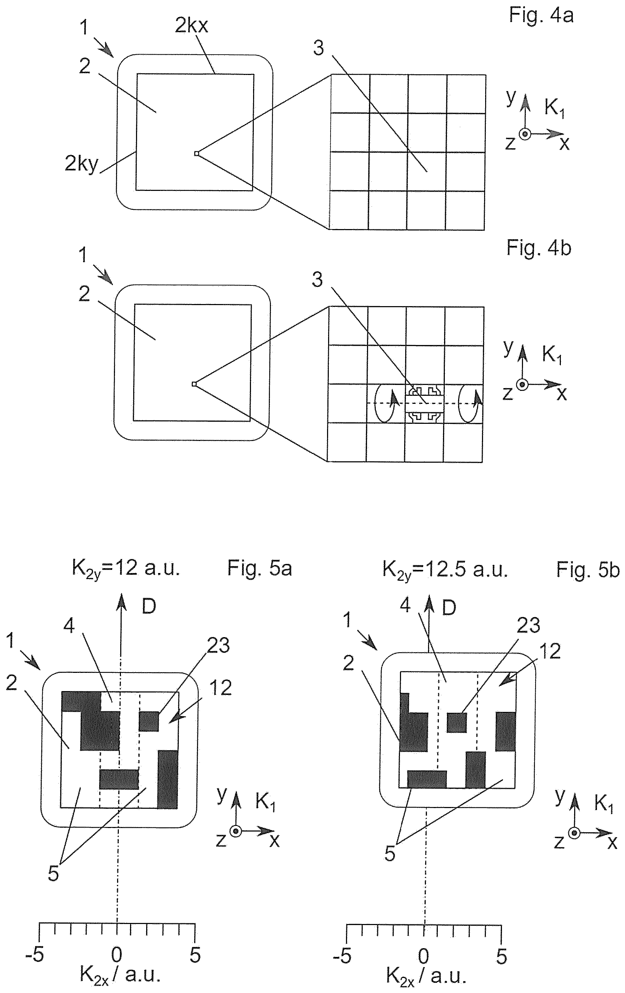

**Figur 4a** zeigt das DMD 1 mit einer Spiegelfläche 2. Die vergrößerte Darstellung eines Teils der Spiegelfläche 2 zeigt mehrere (16) Spiegel 3 einer Vielzahl von Spiegeln 3. Die Spiegel sind in einer nicht gekippten, als Ausgangsposition bezeichneten, Ausrichtung angeordnet. Dem DMD 1 wird ein Koordinatensystem K1 zugeordnet. Die Z-Achse von K1 (also K1z) steht normal auf die Spiegelfläche 2, die x- und die y-Koordinate liegen parallel zu den Spiegelflächenkanten 2kx und 2ky der Spiegelfläche 2 und definieren eine Spiegelebene.

**Figur 4b** zeigt dasselbe DMD 1, wobei einer der Spiegel 3 in einer um die x-Achse gekippten oder gedrehten Position angeordnet ist. Der Teil des Lichtstrahls 6, der auf den gekippten Spiegel 3 trifft, wird daher in einer Richtung reflektiert, die nicht identisch ist zu der Reflexionsrichtung von den nicht gekippten Spiegeln 3 reflektierten Teile des Lichtstrahls 6.

**Figur 5a** zeigt eine schematische Ansicht der Spiegelfläche 2 mit einem zentrischen, insbesondere streifenförmigen, Schreibbereich 4 und zwei jeweils randseitig an den Schreibbereich 4, vorzugsweise parallel, angrenzenden Pufferbereichen 5.

Anstelle der Spiegel 3 werden die von der Spiegelfläche 2 reflektierten Pixel 23 eines Belichtungsrasters 24 dargestellt, welche an der Position K2y=12 auf der zu belichtenden Schicht 9 zu bildenden Strukturen 12 entsprechen (möglicherweise modifiziert durch optische Elemente zwischen dem DMD 1 und der zu belichtenden Schicht 9).

Gemäß einer vorteilhaften erfindungsgemäßen Ausführungsform werden ausschließlich die im Schreibbereich 4 angeordneten Spiegel 3 zum Belichten verwendet, so dass ein Schreibpuffer durch die Pufferbereiche 5 gebildet wird, der nachfolgend erläutert wird. Die Mittellinie D verläuft durch den festgelegten Mittelpunkt 0 der K2x Achse des Probenkoordinatensystem K2.

Die **Figur 5b** zeigt dasselbe DMD 1, allerdings nach einer Relativbewegung in K2y Richtung um 0.5 a.u.. Das DMD 1 befindet sich daher an der Position K2y=12.5 a.u.. Gleichzeitig erkennt man, dass auch eine Relativbewegung in der K2x-Richtung um ca. 2 a.u. stattgefunden hat. Diese Relativbewegung ist ungewollt und rührt beispielsweise von einem Fehler in der Lagerung her. Deutlich erkennbar ist, wie die Struktur 12 in Bezug zum DMD-Koordinatensystem K1 nach links verschoben wurde, um sie in Bezug zum Koordinatensystem K2y korrekt zu belichten. Es wird somit auf den Schreibpuffer zurückgegriffen.

Die gezielte Programmierung des DMDs erlaubt daher die Korrektur mechanischer Fehler. Der Substrathalter 9 bewegt also das Substrat 10 und damit die Schicht 9 nicht vollkommen geradlinig in Richtung K2y, sondern wird während der Bewegung in Richtung K2y leicht nach K2x verschoben.

Erfindungsgemäß (eigenständiger Erfindungsaspekt) bevorzugt wird nicht die Mechanik des Substrathalters 9 zur Fehlerkorrektur verwendet, sondern es werden der Schreibbereich 4 und die Pufferbereiche 5 elektromisch so programmiert/gesteuert, dass die zu belichtenden Strukturen 12 entsprechend verschoben werden (hier in negativer K1x Richtung). Damit kompensiert die Elektronik und/oder die Mechanik des DMDs 1 Schreibfehler, hier den mechanischen Fehler des Substrathalters 11.

Die **Figur 6a** zeigt eine Aufsicht einer entlang eines ersten Streifens 15 belichteten Schicht 9. Der Streifen 15 entspricht dem durch den Schreibbereich 4 des DMD 1 belichteten Bereich der Schicht 9 nach einer Bewegung des DMD 1 relative zu der belichteten Schicht 9 in K2y-Richtung.

In einem Bereich zwischen Intensitätsvariationsbereichen 161, 16r des Streifens 15 werden die beleuchteten Pixel 23 mit einer möglichst homogenen Intensität beleuchtet.

Dagegen werden die beleuchteten Pixel 23 in den Intensitätsvariationsbereichen 161, 16r derart angesteuert, dass die Intensität des reflektierten Lichtstrahls 6' vom Schreibbereich 4 in Richtung des Randes des DMDs 1, insbesondere kontinuierlich, vorzugsweise proportional zur Entfernung vom Schreibbereich 4, abfällt. Ein entsprechendes Rasterintensitätsprofil, an dem man den Intensitätsverlauf als Funktion der Position ablesen kann, ist eingezeichnet (Intensity/Position). Die Intensität, mit der die Schicht 9 belichtet wird, weist somit insbesondere im Bereich des Streifens 15 ein Maximum auf und fällt normal seitlich dazu vorzugsweise stetig und/oder linear bis auf Null ab.

Die **Figur 6b** zeigt eine analoge Darstellung zur Figur 7a betreffend einen zweiten, sich insbesondere direkt an die Belichtung des ersten Streifens 15 anschließenden, Streifen 15'. Dieser ist so weit gegenüber dem ersten Streifen 15 nach rechts verschoben, dass der rechte Intensitätsvariationsbereich 16r aus der Figur 6a mit dem linken Intensitätsvariationsbereich 161' aus der Figur 7b überlappt, vorzugsweise deckungsgleich ist. Die Pixel 23 werden im rechten Intensitätsvariationsbereich 16r genauso verteilt geschaltet wie im linken Intensitätsvariationsbereich 161', wobei die Intensität der korrespondierenden Pixel 23 jeweils zu einer Pixelintensität summiert werden, die der Intensität im Streifen 15 entspricht.

Die **Figur 6c** zeigt eine Aufsicht, wobei der Intensitätsvariationsbereich 16r des ersten Streifens 15 mit dem Intensitätsvariationsbereich 161' des zweiten Streifens 15' zur Deckung gebracht wurden, sodass sich ein konstantes Intensitätsprofil ergibt. Die Belichtung erfolgt somit homogen, da sich die Intensitäten des ersten Streifens 15 mit den Intensitäten des zweiten Streifens 15' summieren.

Die **Figur 7a** zeigt einen vergrößerten Ausschnitt einer erfindungsgemäßen Ausführungsform mit einem DMD 1, optischen Pfaden des primären Lichtstrahls 6 und des sekundären Lichtstrahls 6' und der zu belichtenden Schicht 9. Der primäre Lichtstrahl 6 und der sekundäre Lichtstrahl werden hier nur durch die optischen Pfade 6, 6' symbolisiert und sind vorzugsweise so groß, dass das gesamte DMD 1 beleuchtet wird. Der sekundäre Lichtstrahl 6' steht normal auf die zu belichtende Schicht 9. Die Fokusebene 17 liegt insbesondere parallel zur, vorzugsweise auf der, Oberfläche 9o. Ein Schärfentiefebereich 18 zeigt die Tiefe an, innerhalb der eine scharfe Abbildung der Pixel 23 erfolgen kann.

Die **Figur 7b** zeigt einen vergrößerten Ausschnitt einer bevorzugten, gegenüber der Ausführungsform gemäß Figur 7a geänderten, erfindungsgemäßen Ausführungsform. Der sekundäre Lichtstrahl 6'wird unter einem Winkel α auf die zu belichtende Schicht 9 reflektiert. Die Fokusebene 17 schneidet die zu belichtende Schicht 9 somit unter dem Winkel α. Sie liegt an der linken Seite außerhalb der zu belichtenden Schicht 9, an der rechten Seite in der zu belichtenden Schicht 9. Der Schärfentiefebereich 18 dringt auf der rechten Seite also tiefer in die Schicht 9 ein und kann somit benutzt werden, um scharfe Strukturen bei dreidimensionalen Strukturen in Senken zu erzeugen, ohne die Fokusebene 17 durch Bewegung des DMDs 1 in K2z Richtung zu bewegen.

Die Verschiebung des DMDs 1 in K2z Richtung, um tiefer liegende Strukturen schärfer abbilden zu können, kann insbesondere durch ein Kippen des DMDs 1 umgangen werden. Dynamische Verschiebungen der Belichtungsbereiche am DMD 1 erlauben somit eine gezielte, scharfe Belichtung in entsprechenden Tiefen. Ein wesentlicher Vorteil gegenüber einer Mehrfachbelichtung ist die Möglichkeit, Strukturen hochpräzise ohne mechanische Fehler in allen Raumrichtungen zu erzeugen.

Die **Figur 7c** zeigt einen vergrößerten Ausschnitt einer bevorzugteren, gegenüber den Ausführungsformen gemäß Figur 7a und/oder Figur 7b geänderten, erfindungsgemäßen Ausführungsform. Der sekundäre Lichtstrahl 6' wird durch optische Elemente (nicht eingezeichnet), die sich zwischen dem DMD 1 und der zu belichtenden Schicht 9 befinden, so abgelenkt, dass die Fokusebene 17 zur Substratoberfläche 9o um einen Winkel α geneigt wird.

Die **Figur 8a** zeigt eine Aufsicht auf einen Teilabschnitt der zu belichtenden Schicht 9. Ein Pixel 23 (kleinste Einheit eines Belichtungsrasters 24) wurde durch das DMD 1 entlang einer Länge 1 beleuchtet, indem eine Relativbewegung zwischen dem DMD 1 (nicht eingezeichnet) und der zu belichtenden Schicht 9 stattgefunden hat und während des gesamten Verfahrweges entlang der Länge 1 eine Belichtung der Schicht 9 im Bereich der Breite b durch Beleuchtung des Pixels 23 stattgefunden hat. Die belichteten Bereiche entsprechen den Pixeln 23, wobei die Intensität der Belichtung durch die Beleuchtungsintensität gesteuert wird. Bei Überlappungen summieren sich die Intensitäten im überlappenden Bereichen.

Die Belichtung erfolgte von der K2y Position 0 bis zur K2y Position 3. Eine Verwaschung in Relativbewegungsrichtung wird dadurch erzeugt, dass während der Relativbewegung mehrere Belichtungen innerhalb des Bereichs von ca. -2 bis 5 stattfinden. Die Intensitätsprofile der Pixel 23 überlagern sich und erzeugen eine starke Intensitätserhöhung entlang der Strecke 1.

Die **Figur 8b** zeigt alternative Ausführungsform zur Figur 8a, wobei der Unterschied zur Figur 8a darin besteht, dass die kleinere Länge 1' dadurch erzeugt wurde, dass der korrespondierende Spiegel 3 des DMDs 1 (beide nicht eingezeichnet), erst ab der K2y Position 1 mit der Belichtung begonnen, und die Belichtung bereits ab der K2y Position 2 beendet hat. Durch die gezielte Ansteuerung der Spiegel 3, insbesondere das spätere Ein- bzw. frühere Ausschalten ist daher eine Erhöhung der Auflösung in K2y Richtung möglich. Im konkreten Fall wird daher die Belichtung des Pixels 23 um 33,33 % verzögert begonnen und um 33,33% frühzeitig beendet. Da es nicht möglich ist, den Pixel 23 quadratisch zu belichten, da jeder Strahl ein Intensitätsprofil besitzt das von einer Stufenform abweicht. Die im Folgenden beschriebenen Belichtungsraster 24, 24', 24", 24‴ sind als Hilfslinien dargestellt, die man sich über die zu belichtende Schicht 9 liegend vorstellen kann. Vorzugsweise entsprechen die Raster den Abmessungen der Pixel 23.

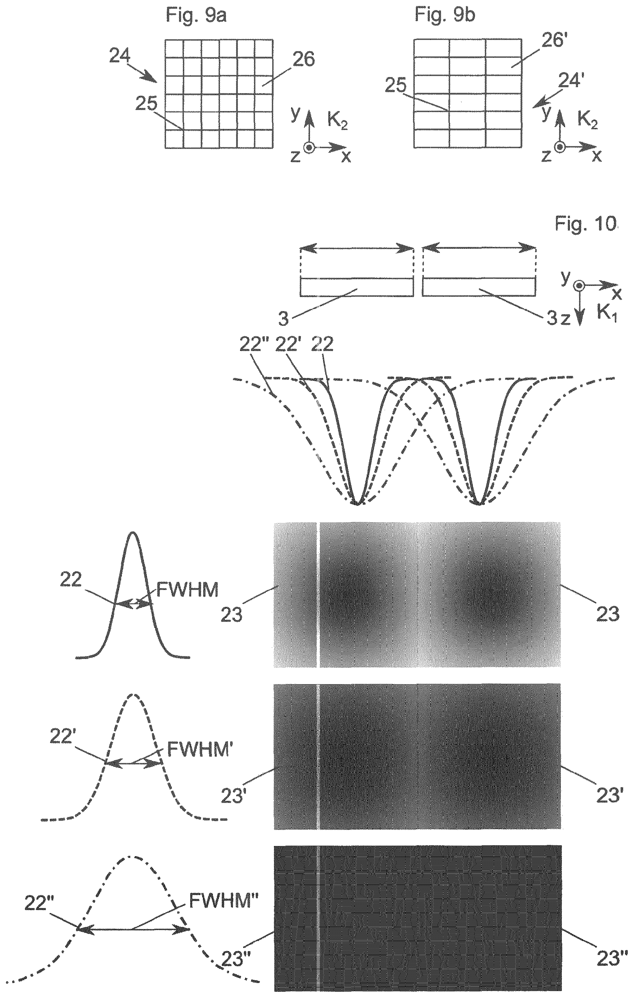

Die **Figur 9a** zeigt ein erstes, erfindungsgemäß weniger bevorzugtes Belichtungsraster 24, das in die beiden, zueinander orthogonalen Richtungen K2x, K2y äquidistante Abstände der Belichtungsrastergitterlinien 27 besitzt. Das Belichtungsraster 24 ist damit isotrop und homogen in beide Richtungen K2x und K2y.

Die **Figur 9b** zeigt ein zweites, erfindungsgemäß bevorzugteres Belichtungsraster 24', das für jede Richtung einen eigenen, insbesondere bezogen auf die Richtung äquidistanten, Abstand zwischen den Belichtungsrastergitterlinien 27 besitzt. Das Belichtungsraster 24' ist damit anisotrop, aber homogen in jeder der Richtungen K2x und K2y.

Denkbar ist auch, dass die Belichtung an
Belichtungsrastergitterlinienschnittpunkten 25 und/oder
Belichtungsrasterteilflächen 26 und nicht innerhalb der einzelnen Rasterflächen erfolgt.

Die unterschiedlichen Belichtungsraster 24, 24', 24", 24"'. können insbesondere durch dem DMD 1 (nicht eingezeichnet) vor- und/oder nachgelagerte optische Elemente (nicht eingezeichnet) erzeugt/modifiziert werden. Das DMD 1 (nicht eingezeichnet) wäre vorzugsweise isotrop und homogen, wobei die, insbesondere nur die nachgeschalteten, optischen Elemente (nicht eingezeichnet), eine anisotrope und/oder nicht homogene Abbildung des DMDs bewirkend ausgebildet sind.

Die **Figur 10** zeigt eine schematische Querschnittsdarstellung zweier Spiegel 3, sowie die durch drei unterschiedliche Parametersätze und/oder konstruktionstechnische Änderungen der Spiegel 3 zustande kommende Spiegelintensitätsprofile 22, 22', 22' (insbesondere Gauß-Profile), sowie die durch diese Spiegelintensitätsprofile 22, 22', 22" erzeugte Pixel 23, 23', 23". Erkennbar ist, dass die Intensitätsverteilung mit zunehmenden Parametern welche die Verteilungsfunktionen charakterisieren, insbesondere den Halbwertsbreiten FWHM, FWHM', FWHM" (engl.: full width at half maximum, FWHM), immer stärker überlappen, sodass zwei nebeneinanderliegende Pixel 23, 23', 23 "stärker verwaschen werden. Das Resultat ist ein sehr homogenes Belichtungsraster bei den am stärksten überlagerten Pixeln 23".

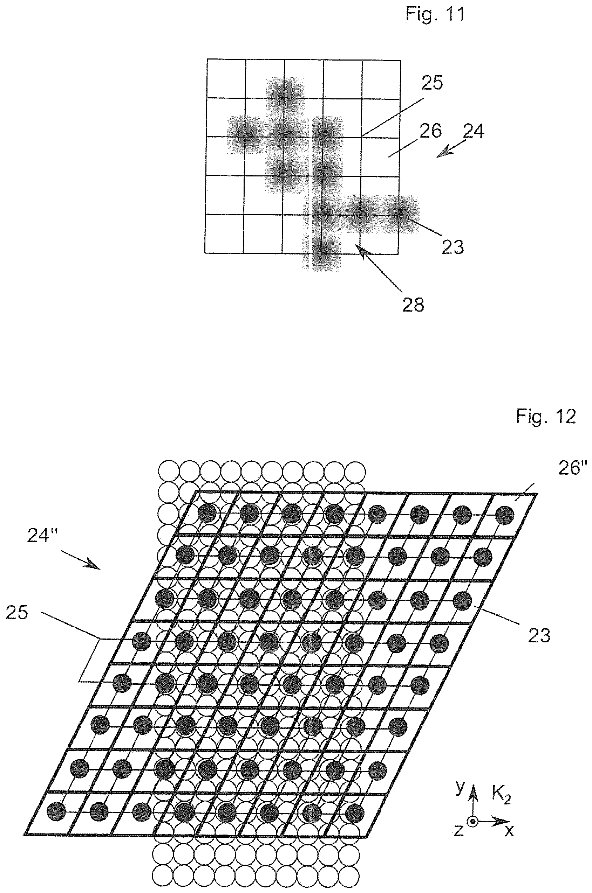

Die **Figur 11** zeigt eine schematische, nicht maßstabsgetreue Aufsicht mehrerer Pixel 23 auf einem 5x5 Belichtungsraster 24. Erkennbar ist ein Muster 28, dass durch die gezielte Schaltung der korrespondierenden Spiegel 3 beleuchtet wird. Die Spiegelintensitätsprofile der Spiegel 3 sind so scharf, dass die Intensitätsmaxima klar erkennbar sind und der Abfall der Intensität so stark ist, dass die Intensitätsverteilung pro Spiegel 3 (nicht eingezeichnet) sehr stark auf die zugeordnete Belichtungsrasterteilfläche 26 begrenzt ist. In besonders bevorzugten erfindungsgemäßen Ausführungsformen werden die Spiegelintensitätsprofile teilweise über die Belichtungsrasterteilfläche 26 hinaus überlagert, wie es bei der Ausführung der Pixel 23" gemäß Figur 10 der Fall wäre.

Die **Figur 12** zeigt eine schematische, nicht maßstabsgetreue Aufsicht eines, insbesondere durch optische Elemente des optischen Systems 8, verzerrten Belichtungsrasters 24". Durch die optischen Elemente werden die von den Spiegeln 3 des DMDs 1 reflektierten Teilstrahlen orthogonal auf die zu belichtende Schicht 9 reflektiert, allerdings erfolgt, vorzugsweise ausschließlich, eine Verzerrung innerhalb der K2x-K2y Ebene. Durch dieses erfindungsgemäße Verfahren kann ein Belichtungsraster 24" optisch geschaffen werden, das zu einer erfindungsgemäßen Erhöhung des Overlays führt. Das DMD 1 wird bei dieser Ausführungsform vorzugsweise nicht schräg gestellt, sondern das Urbild des DMD 1 wird affin verzerrt, um die Schrägstellung des Belichtungsrasters 24" zu bewirken.

### Bezugszeichenliste

- 1: DMD
- 2: Spiegelfläche
- 2kx, 2ky: Spiegelflächenkanten
- 3,3': Spiegel
- 4: Schreibbereich
- 5: Pufferbereich
- 6: Lichtstrahl
- 6': modifizierter/strukturierter Lichtstrahl
- 6.1': erster modifizierter Strahl
- 6.2': zweiter modifizierter Strahl
- 7, 7': Lichtquellen
- 8: Optisches System
- 9: Schicht
- 10: Substrat
- 11: Substrathalter
- 12, 12', 12": Strukturen
- 13: Fixiermittel
- 14: Spiegel
- 14': Strahlteiler
- 14": halbdurchlässiger Spiegel
- 15, 15',15": Streifen
- 161,16r,161',16r',16r": Intensitätsvariationsbereich
- 17: Fokusebene
- 18: Tiefenschärfe
- 19: Detektor
- 20: Punktraster
- 22, 22', 22": Spiegelintensitätsprofile
- 23, 23': Pixel
- 24, 24', 24", 24‴: Belichtungsraster
- 25: Belichtungsrastergitterlinienschnittpunkt
- 26: Belichtungsrasterteilfläche
- 27: Belichtungsrastergitterlinie
- 28: Muster
- 1, 1': Länge
- b: Breite
- D: Verfahrrichtung
- v: Vertikaler Punktrasterabstand
- h: Horizontaler Punktrasterabstand
- r: Belichtungspunktradius
- p: Spiegelzentrumsabstand

## Patentansprüche

1. Verfahren zur Belichtung einer lichtempfindlichen Schicht (9) mit einem optischen System (8), wobei mindestens ein Lichtstrahl (6, 6') jeweils von mindestens einer Lichtquelle (7) erzeugt wird und Pixel (23) eines Belichtungsrasters (24, 24', 24", 24‴) durch mindestens eine Mikrospiegeleinrichtung (1) mit einer Vielzahl von Mikrospiegeln (3) jeweils mit einem Spiegelintensitätsprofil (22, 22', 22") und einen kontinuierlich und/oder sequentiell abtastenden, maskenlosen Belichter beleuchtet werden, **dadurch gekennzeichnet, dass** eine Überlagerung von Spiegelintensitätsprofilen (22, 22', 22") benachbarter Mikrospiegel (3) zu einem Rasterintensitätsprofil des Belichtungsrasters (24, 24', 24", 24‴) als Summe der Spiegelintensitätsprofile (22, 22', 22") jedes beleuchteten Pixels (23) des Belichtungsrasters (24, 24', 24", 24‴) erfolgt.

2. Verfahren nach Anspruch 1, wobei das optische System (8) in eine, von einer ersten Richtung des kontinuierlich und/oder sequentiell abtastenden, maskenlosen Belichters abweichenden, insbesondere normal zur ersten Richtung angeordneten, zweiten Richtung verschoben wird.

3. Verfahren nach Anspruch 1 oder 2, wobei die Spiegelintensitätsprofile, insbesondere auf Grund der geometrischen Form der Mikrospiegel (3), Pixel (23) erzeugen, die größer sind als einzelne Raster des Belichtungsrasters (24, 24', 24", 24‴).

4. Verfahren nach einem der vorhergehenden Ansprüche, wobei mindestens zwei Belichtungsraster (24, 24', 24", 24‴), insbesondere sequentiell, beleuchtet werden und die Rasterintensitätsprofile der Belichtungsraster (24, 24', 24", 24‴) als Summe zu einem Belichtungsintensitätsprofil der lichtempfindlichen Schicht (9) überlagert werden.

5. Verfahren nach einem der vorhergehenden Ansprüche, wobei die Überlagerung durch unscharfe Abbildung der Mikrospiegel (3) im Belichtungsraster (24, 24', 24", 24‴) erfolgt.

6. Verfahren nach einem der Ansprüche 4 oder 5, wobei zwei sequentiell hintereinander beleuchtete Belichtungsraster (24, 24', 24", 24‴) mit einer relativen Verschiebung zwischen der Mikrospiegeleinrichtung (1) und der lichtempfindlichen Schicht (9) um weniger als eine Pixelbreite, vorzugsweise weniger als eine halbe Pixelbreite, noch bevorzugter weniger als eine Viertel Pixelbreite, verschoben werden.

7. Verfahren nach einem der vorhergehenden Ansprüche, wobei, insbesondere parallel zueinander verlaufende, horizontale und/oder, insbesondere parallel zueinander verlaufende, vertikale Belichtungsrastergitterlinien des Belichtungsrasters (24, 24', 24", 24‴) schräg verlaufend angeordnet und/oder, insbesondere affin, verzerrt werden.

8. Vorrichtung zur Belichtung einer lichtempfindlichen Schicht (9) mit einem optischen System (8) mit:
- mindestens einer Lichtquelle (7) zur Erzeugung mindestens eines Lichtstrahls (6, 6'),
- einem kontinuierlich und/oder sequentiell abtastenden, maskenlosen Belichter,
- mindestens eine Mikrospiegeleinrichtung (1) mit einer Vielzahl von Mikrospiegeln (3), wobei jeder Mikrospiegel (3) zur Beleuchtung eines Pixels (23) eines Belichtungsrasters (24, 24', 24", 24‴) mit einem Spiegelintensitätsprofil (22, 22', 22") dient,
**dadurch gekennzeichnet, dass** das optische System (8) derart ausgebildet ist, dass eine Überlagerung von Spiegelintensitätsprofilen (22, 22', 22") benachbarter Mikrospiegel (3) zu einem Rasterintensitätsprofil des Belichtungsrasters (24, 24', 24", 24‴) als Summe der Spiegelintensitätsprofile (22, 22', 22") jedes beleuchteten Pixels (23) des Belichtungsrasters (24, 24', 24", 24‴) erfolgt.

## Claims

1. A method for exposing a light-sensitive layer (9) with a optical system (8), wherein at least one light beam (6, 6') is produced by at least one light source (7) and pixels (23) of a exposure raster (24, 24', 24", 24‴) are illuminated by at least one micromirror device (1) with a plurality of micromirrors (3) each with a mirror intensity profile (22, 22', 22") and a continuous and/or sequential scanning, maskless imagesetter, **characterised by** the fact that a superposition of mirror intensity profiles (22, 22', 22") of adjacent micromirrors (3) to form a raster intensity profile of the exposure raster (24, 24' 24" 24‴) takes place as the sum of the mirror intensity profiles (22, 22', 22") of each illuminated pixel (23) of the exposure raster (24, 24', 24" 24‴).

2. The method according to claim 1, wherein the optical system (8) is shifted into a second direction deviating from a first direction of the continuously and/or sequentially scanning, maskless imagesetter, in particular arranged normal to the first direction.

3. The method according to claim 1 or 2, wherein the mirror intensity profiles, in particular due to the geometric shape of the micromirrors (3), generate pixels (23) that are larger than individual grids of the exposure raster (24, 24', 24", 24"').

4. The method according to any one of the preceding claims, wherein at least two exposure rasters (24, 24', 24", 24"') are illuminated, in particular sequentially, and the raster intensity profiles of the exposure rasters (24, 24', 24", 24"') are superimposed as a sum to form an exposure intensity profile of the light-sensitive layer (9).

5. The method according to any one of the preceding claims, wherein the superposition takes place by blurred image of the micromirrors (3) in the exposure raster (24, 24', 24", 24"').

6. The method according to any one of claims 4 or 5, wherein two exposure rasters (24, 24', 24", 24‴) illuminated sequentially one after another are displaced with a relative displacement between the micromirror device (1) and the light-sensitive layer (9) of less than one pixel width, preferably less than half a pixel width, even more preferably less than a quarter of a pixel width.

7. The method according to any one of the preceding claims, wherein exposure raster grid lines of the exposure raster (24, 24', 24", 24‴) that are horizontal and, in particular, running parallel to one, and/or that are vertical and, in particular, running parallel to one another are arranged running distorted and/or are, in particular affine.

8. A device for exposing a light-sensitive layer (9) with an optical system (8) comprising:
- at least one light source (7) for generating of at least one light beam (6, 6'),
- a continuously and/or sequentially scanning, maskless imagesetter,
- at least one micromirror device (1) with a plurality of micromirrors (3), wherein each micromirror (3) serves to illuminate one pixel (23) of an exposure raster (24, 24', 24", 24"') with a mirror intensity profile (22, 22', 22"),
**characterised in that**
the optical system (8) is designed in such a way that a superposition of mirror intensity profiles (22, 22', 22") of adjacent micromirrors (3) to form a raster intensity profile of the exposure raster (24, 24', 24", 24"') takes place as the sum of the mirror intensity profiles (22, 22', 22") of each illuminated pixel (23) of the exposure raster (24, 24', 24", 24‴).

## Revendications

1. Procédé d'éclairage d'une couche sensible à la lumière (9) avec un système optique (8), dans lequel au moins un rayon lumineux (6, 6') est produit par respectivement au moins une source de lumière (7), et des pixels (23) d'une trame d'éclairage (24, 24', 24", 24"') sont éclairés par au moins un dispositif de micro-miroirs (1) comprenant une pluralité de micro-miroirs (3), respectivement avec un profil d'intensité de miroir (22, 22', 22") et une insoleuse sans masque à balayage continu et/ou séquentiel, **caractérisé en ce qu'**une superposition de profils d'intensité de miroir (22, 22', 22") de micro-miroirs (3) voisins à un profil d'intensité de trame de la trame d'éclairage (24, 24', 24", 24‴) est réalisée en tant que somme des profils d'intensité de miroir (22, 22', 22") de chaque pixel (23) éclairé de la trame d'éclairage (24, 24', 24", 24‴).

2. Procédé selon la revendication 1, dans lequel le système optique (8) est décalé dans une seconde direction s'écartant d'une première direction de l'insoleuse sans masque à balayage continu et/ou séquentiel, en particulier disposée normale à une première direction.

3. Procédé selon la revendication 1 ou 2, dans lequel les profils d'intensité de miroir, en particulier en raison de la forme géométrique des micro-miroirs (3), produisent des pixels (23) qui sont plus grands que des trames individuelles de la trame d'éclairage (24, 24', 24", 24‴).

4. Procédé selon au moins l'une des revendications précédentes, dans lequel au moins deux trames d'éclairage (24, 24', 24", 24"'), sont éclairées, en particulier de manière séquentielle, et les profilés d'intensité de trame des trames d'éclairage (24, 24', 24", 24''') sont superposés à un profil d'intensité d'éclairage de la couche sensible à la lumière (9) en tant que somme.

5. Procédé selon au moins l'une des revendications précédentes, dans lequel la superposition s'effectue par une reproduction floue des micro-miroirs (3) dans la trame d'éclairage (24, 24', 24", 24‴).

6. Procédé selon au moins l'une des revendications 4 ou 5, dans lequel deux trames d'éclairage (24, 24', 24", 24‴) éclairées de manière séquentielle l'une derrière l'autre sont décalées avec un décalage relatif entre le dispositif de micro-miroirs (1) et la couche sensible à la lumière (9) de moins d'une largeur de pixel, de préférence de moins d'une demi-largeur de pixel, de manière plus préférée de moins d'un quart de largeur de pixel.

7. Procédé selon au moins l'une des revendications précédentes, dans lequel des lignes de grille de trame d'éclairage horizontales, en particulier parallèles entre elles, et/ou verticales, en particulier parallèles entre elles de la
trame d'éclairage (24, 24', 24", 24‴) sont disposées en étant de biais et/ou déformées, en particulier affines.

8. Dispositif d'éclairage d'une couche sensible à la lumière (9) avec un système optique (8), comprenant :
- au moins une source de lumière (7) pour produire au moins un rayon lumineux (6, 6'),
- une insoleuse sans masque à balayage continu et/ou séquentiel
- au moins un dispositif de micro-miroirs (1) comprenant une pluralité de micro-miroirs (3), dans lequel chaque micro-miroir (3) sert à éclairer un pixel (23) d'une trame d'éclairage (24, 24', 24", 24‴) avec un profil d'intensité de miroir (22, 22', 22"),
**caractérisé en ce que** le système optique (8) est ainsi conçu qu'une superposition de profils d'intensité de miroir (22, 22', 22") de micro-miroirs (3) voisins à un profil d'intensité de trame de la trame d'éclairage (24, 24', 24", 24''') est réalisée en tant que somme des profils d'intensité de miroir (22, 22', 22") de chaque pixel (23) éclairé de la trame d'éclairage (24, 24', 24", 24‴).
